# EUROPEAN PATENT APPLICATION

(11) **EP 4 842 162 A1**
(43) Date of publication of application: **18.11.2026**
(21) Application number: 26150825.3
(22) Date of filing: 08.01.2026
(51) Int. Cl.: H10D 64/27, H10D 30/01, H10D 30/43, H10D 30/00, H10D 64/66

(54) **SEMICONDUCTOR DEVICE WITH FILLER CONDUCTIVE LAYER BETWEEN INNER CONDUCTIVE LAYERS OF A GATE STRUCTURE**

(30) Priority: 14.05.2025 KR 20250062785
(71) Applicant: Samsung Electronics Co., Ltd., Suwon-si, Gyeonggi-do 16677 (KR)
(72) Inventor: JEONG, Chungbu, 16677 Suwon-si (KR); KIM, Seon-Bae, 16677 Suwon-si (KR)
(74) Representative: Marks & Clerk LLP

(57) **Abstract**

A semiconductor device including: a source/drain pattern; a semiconductor pattern connected to the source/drain pattern; a gate structure overlapping the semiconductor pattern; and a gate dielectric layer between the gate structure and the semiconductor pattern. The gate structure includes: a first and second inner conductive layers; and a filler conductive layer on the first and second inner conductive layers. The filler conductive layer includes first and second portions. The first and second portions are between the first and second inner conductive layers. The first portion and the second portion are spaced apart from each other. The second inner conductive layer is between the first portion and the second portion. A first sidewall of the first portion and a bottom surface of the first portion are in contact with the first inner conductive layer. A second sidewall of the first portion is in contact with the second inner conductive layer.

## Description

### BACKGROUND

The disclosure relates to a semiconductor device, and more particularly, to a semiconductor device in which a gate structure includes conductive layers.

Semiconductor devices are essential elements in the electronic industry because of their properties such as compactness, multi-functionality, and/or low manufacturing cost. Semiconductor devices may encompass semiconductor memory devices storing logic data, semiconductor logic devices processing operations of logic data, and hybrid semiconductor devices having both memory and logic elements.

Recently, high speed and low power consumption in electronic products require that semiconductor devices embedded in the electronic products should have high operating speed and/or lower operating voltage. However, an increase in integration of semiconductor devices may cause a reduction in electrical properties and production yield of semiconductor devices. Therefore, many studies have been conducted to increase electrical properties and production yield of semiconductor devices.

### SUMMARY

Provided is a semiconductor device with improved electrical properties.

According to an aspect of the disclosure, a semiconductor device includes: a source/drain pattern; a semiconductor pattern connected to the source/drain pattern; a gate structure that overlaps the semiconductor pattern; and a gate dielectric layer between the gate structure and the semiconductor pattern, wherein the gate structure includes: a first inner conductive layer; a second inner conductive layer on the first inner conductive layer; and a filler conductive layer on the first inner conductive layer and the second inner conductive layer, wherein the filler conductive layer includes a first portion and a second portion, wherein the first portion of the filler conductive layer and the second portion of the filler conductive layer are between the first inner conductive layer and the second inner conductive layer, wherein the first portion of the filler conductive layer and the second portion of the filler conductive layer are spaced apart from each other, wherein the second inner conductive layer is between the first portion of the filler conductive layer and the second portion of the filler conductive layer, wherein a first sidewall of the first portion of the filler conductive layer and a bottom surface of the first portion of the filler conductive layer are in contact with the first inner conductive layer, and wherein a second sidewall of the first portion of the filler conductive layer is in contact with the second inner conductive layer.

According to an aspect of the disclosure, a semiconductor device includes: a source/drain pattern; a semiconductor pattern connected to the source/drain pattern; a first gate structure that overlaps the semiconductor pattern; and a gate dielectric layer between the first gate structure and the semiconductor pattern, wherein the first gate structure includes: an outer conductive layer on the gate dielectric layer; a first inner conductive layer on the outer conductive layer and spaced apart from the gate dielectric layer; a second inner conductive layer on the first inner conductive layer and spaced apart from the outer conductive layer; and a filler conductive layer on the first inner conductive layer and the second inner conductive layer, wherein the filler conductive layer of the first gate structure includes a first portion and a second portion, wherein the first portion of the filler conductive layer of the first gate structure and the second portion of the filler conductive layer of the first gate structure are between the first inner conductive layer of the first gate structure and the second inner conductive layer of the first gate structure, wherein the first portion of the filler conductive layer of the first gate structure and the second portion of the filler conductive layer of the first gate structure are spaced apart from each other, wherein the second inner conductive layer of the first gate structure is between the first portion of the filler conductive layer of the first gate structure and the second portion of the filler conductive layer of the first gate structure, and wherein the first portion of the filler conductive layer of the first gate structure and the second portion of the filler conductive layer of the first gate structure are spaced apart from the outer conductive layer of the first gate structure.

According to an aspect of the disclosure, a semiconductor device includes: a source/drain pattern; a semiconductor pattern connected to the source/drain pattern; a gate structure that overlaps the semiconductor pattern; and a gate dielectric layer between the gate structure and the semiconductor pattern from, wherein the gate structure includes: a first inner conductive layer spaced apart from the gate dielectric layer; a second inner conductive layer on the first inner conductive layer; and a filler conductive layer on the first inner conductive layer and the second inner conductive layer, wherein the filler conductive layer includes a first portion and a second portion that are spaced apart from each other, wherein the second inner conductive layer is between the first portion of the filler conductive layer and the second portion of the filler conductive layer, and wherein a bottom surface of the first portion of the filler conductive layer and a bottom surface of the second portion of the filler conductive layer are in contact with the first inner conductive layer.

According to an aspect of the disclosure, a method of manufacturing a semiconductor device includes: providing a substrate; alternately forming semiconductor layers and sacrificial layers on the substrate; patterning the substrate to form first, second, third, and fourth fin patterns; forming first sacrificial patterns which extend in a first direction and are spaced apart from each other in a second direction and forming second sacrificial patterns which extend in the first direction and are spaced apart from each other in the second direction, wherein one or more of the first sacrificial patterns intersect the first fin pattern and the second fin pattern, and one or more of the first sacrificial patterns does not overlap the first fin pattern and the second fin pattern; forming a first source/drain pattern, a second source/drain pattern, a third source/drain pattern, and a fourth source/drain patterns; removing the first and the second sacrificial patterns to expose first, second, third, and fourth semiconductor patterns; forming a gate dielectric layer on the first, second, third, and fourth fin patterns and on the first, second, third, and fourth semiconductor patterns; forming a first preliminary conductive layer on the gate dielectric layer, the first preliminary conductive layer including a first portion between the first semiconductor patterns, a second portion between the second semiconductor patterns, a third portion between the third semiconductor patterns, and a fourth portion between the fourth semiconductor patterns; forming a second preliminary conductive layer on the first preliminary conductive layer, wherein a top surface of the second preliminary conductive layer defines a first recess spaced apart in the second direction from the first fin pattern, a second recess spaced apart in a third direction from the second semiconductor pattern, a third recess that overlaps in the third direction with the first semiconductor pattern, and a fourth recess that overlaps in the third direction with the fourth semiconductor pattern; forming a preliminary dielectric pattern on the second preliminary conductive layer; etching a portion of the preliminary dielectric pattern to expose the top surface of the second preliminary conductive layer and to form a first dielectric pattern, a second dielectric pattern, a third dielectric pattern, a fourth dielectric pattern, a fifth dielectric pattern, a sixth dielectric pattern, and a seventh dielectric pattern, wherein the first, second, third, fourth, fifth, sixth, and seventh dielectric patterns are spaced apart from each other in the second direction and the seventh dielectric pattern fills a portion of the fourth recess; forming a third preliminary conductive layer on the second preliminary conductive layer and the first, second, third, fourth, fifth, sixth, and seventh dielectric patterns, wherein he third preliminary conductive layer fills a gap between the first and second dielectric patterns, a gap between the third and fourth dielectric patterns, and a gap between the fifth and sixth dielectric patterns; etching a portion of each of the first preliminary conductive layer, the second preliminary conductive layer, and the third preliminary conductive layer to form a first preliminary gate structure, a second preliminary gate structure, a third preliminary gate structure, and a preliminary outer gate structure; etching portions of a first inner conductive layer and a second inner conductive layer of the first preliminary gate structure to allow the fifth dielectric pattern and the sixth dielectric pattern to protrude from the first preliminary gate structure; etching portions of a first inner conductive layer and a second inner conductive layer of the second preliminary gate structure to allow the third dielectric pattern and the fourth dielectric pattern to protrude from the second preliminary gate structure; etching a portion of an inner conductive layer of the third preliminary gate structure to allow the seventh dielectric pattern to protrude from the first preliminary gate structure; removing a portion of the first dielectric pattern, a portion of the second dielectric pattern, and the third, fourth, fifth, sixth, and seventh dielectric patterns; forming a filler conductive layer on the first preliminary gate structure, the second preliminary gate structure, the third preliminary gate structure, and the preliminary outer gate structure; forming a preliminary gate capping layer to cover the first, second, and third gate structures, the outer gate structure, the first interlayer dielectric layer, and the gate spacer; and etching the preliminary gate capping layer.

According to an aspect of the disclosure, a method of manufacturing a semiconductor device includes: forming a semiconductor pattern and a source/drain pattern connected to the semiconductor pattern; forming a gate dielectric layer on the semiconductor pattern; forming an outer conductive layer on the gate dielectric layer; forming a first inner conductive layer on the outer conductive layer; forming a first dielectric pattern and a second dielectric pattern on the first inner conductive layer; forming a second inner conductive layer between the first dielectric pattern and the second dielectric pattern; removing the first dielectric pattern and the second dielectric pattern; and forming a filler conductive layer on the second inner conductive layer, wherein the filler conductive layer comprises a first portion and a second portion, wherein the first portion of the filler conductive layer and the second portion of the filler conductive layer are between the first inner conductive layer and the second inner conductive layer, wherein the first portion of the filler conductive layer and the second portion of the filler conductive layer are spaced apart each other; wherein the second inner conductive layer is between the first portion of the filler conductive layer and the second portion of the filler conductive layer, wherein a first sidewall of the first portion of the filler conductive layer and a bottom surface of the first portion of the filler conductive layer are in contact with the first inner conductive layer, and wherein a second sidewall of the first portion of the filler conductive layer is in contact with the second inner conductive layer.

In the method for manufacturing a semiconductor device, the filler conductive layer comprises a first conductive material, and the first inner conductive layer and the second inner conductive layer each comprise a second conductive material different from the first conductive material.

In the method for manufacturing a semiconductor device, the method further includes: before removing the first dielectric pattern and the second dielectric pattern, forming a preliminary conductive layer covering the first dielectric pattern and the second dielectric pattern; and exposing the first dielectric pattern and the second dielectric pattern by etching the preliminary conductive layer.

In the method for manufacturing a semiconductor device, the first inner conductive layer comprises: a first inner sidewall in contact with the first portion of the filler conductive layer; a second inner sidewall in contact with the second portion of the filler conductive layer; and a connection surface that connects the first inner sidewall and the second inner sidewall to each other, and the first portion of the filler conductive layer, the second portion of the filler conductive layer, and the second inner conductive layer are in contact with the connection surface of the first inner conductive layer.

In the method for manufacturing a semiconductor device, the first sidewall of the first portion of the filler conductive layer and the second sidewall of the first portion of the filler conductive layer are opposite to each other.

In the method for manufacturing a semiconductor device, a first sidewall of the second portion of the filler conductive layer and a bottom surface of the second portion of the filler conductive layer are in contact with the first inner conductive layer, and a second sidewall of the second portion of the filler conductive layer is in contact with the second inner conductive layer.

In the method for manufacturing a semiconductor device, the filler conductive layer further comprises a third portion that covers the second inner conductive layer and that connects the first portion of the filler conductive layer and the second portion of the filler conductive layer to each other.

In the method for manufacturing a semiconductor device, the gate dielectric layer is between the semiconductor pattern and the outer conductive layer.

In the method for manufacturing a semiconductor device, the outer conductive layer is between the gate dielectric layer and the first inner conductive layer.

In the method for manufacturing a semiconductor device, the first dielectric pattern and the second dielectric pattern overlap the semiconductor pattern.

At least some of the above and other features of the invention are set out in the claims.

### BRIEF DESCRIPTION OF DRAWINGS

The above and other aspects and features of certain embodiments of the present disclosure will be more apparent from the following description taken in conjunction with the accompanying drawings, in which:
FIG. 1A illustrates a plan view showing a semiconductor device according to one or more embodiments.;
FIG. 1B illustrates a cross-sectional view taken along line I-I' of FIG. 1A;
FIG. 1C illustrates a cross-sectional view taken along line II-II' of FIG. 1A;
FIG. 1D illustrates a cross-sectional view taken along line III-III' of FIG. 1A;
FIG. 1E illustrates an enlarged view showing section A of FIG. 1B;
FIG. 1F illustrates an enlarged view showing section B of FIG. 1B;
FIG. 1G illustrates an enlarged view showing section C of FIG. 1B;
FIG. 1H illustrates an enlarged view showing section D of FIG. 1D;
FIG. 2A, 2B, 2C, 2D, 3A, 3B, 3C, 3D, 4A, 4B, 4C, 5A, 5B, 5C, 5D, 6A, 6B, 6C, 7A, 7B, 7C, 8A, 8B, 8C, 9A, 9B, 9C, 9D, 10A, 10B, 10C, 11A, 11B, 11C, 12A, 12B, 12C, 13A, 13B, 13C, 14A, 14B, 14C, 15A, 15B and 15C illustrate diagrams showing a method of fabricating a semiconductor device in accordance with FIGS. 1A to 1H;
FIGS. 16A and 16B illustrate cross-sectional views showing a semiconductor device according to one or more embodiments;
FIGS. 17A to 17D illustrate cross-sectional views showing a semiconductor device according to one or more embodiments; and
FIGS. 18A to 18G illustrate cross-sectional views showing a semiconductor device according to one or more embodiments.

### DETAILED DESCRIPTION

It will be hereinafter discussed a semiconductor device and a method of fabricating the same according to one or more embodiments of the disclosure in conjunction with the accompanying drawings.

In the following description, like reference numerals refer to like elements throughout the specification.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only a configuration where the member is in contact with the other member, but also a configuration where there is another member between the two members.

As used herein, the expressions "at least one of a, b or c" and "at least one of a, b and c" indicate "only a," "only b," "only c," "both a and b," "both a and c," "both b and c," and "all of a, b, and c."

It will be understood that, although the terms "first", "second", "third", etc., may be used herein to describe various elements, the disclosure is not be limited by these terms, and these terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

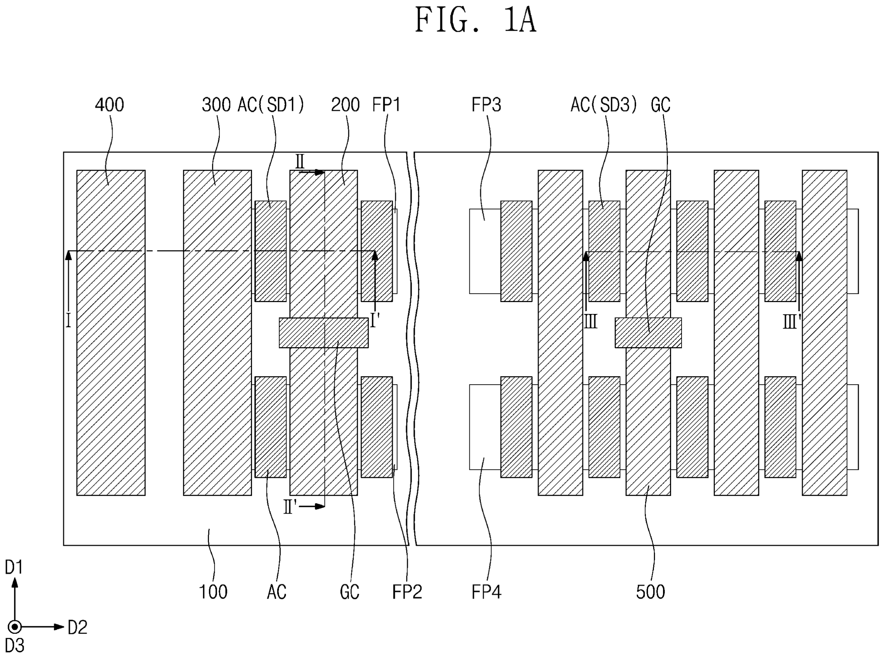

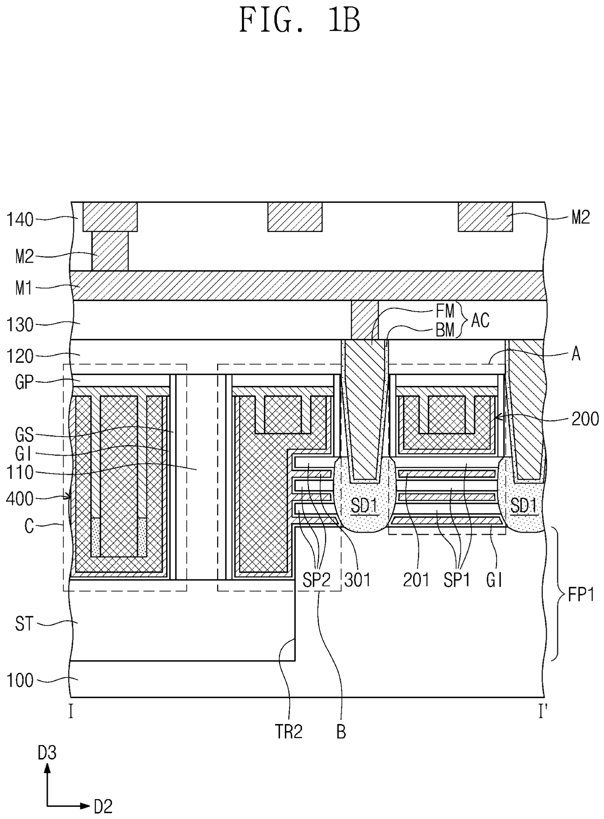

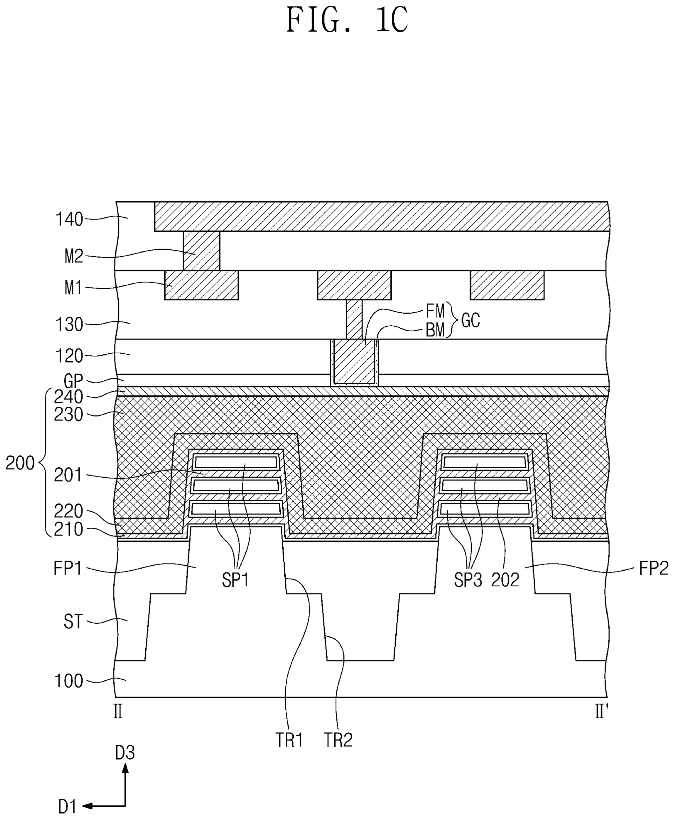

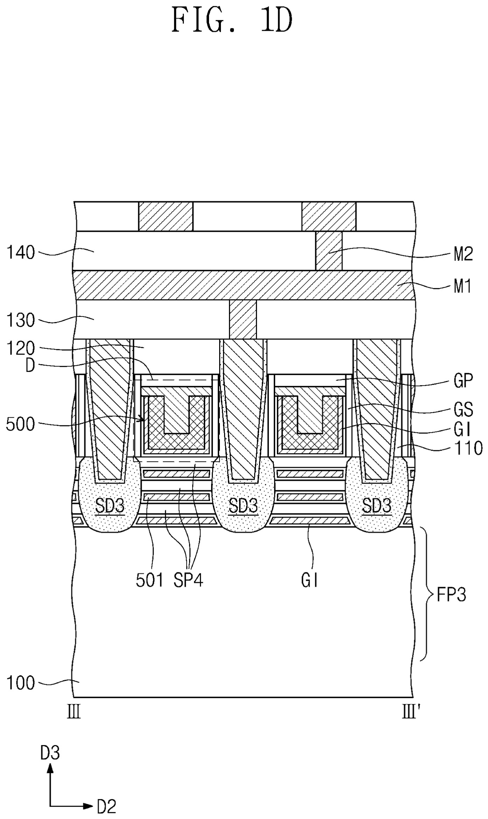

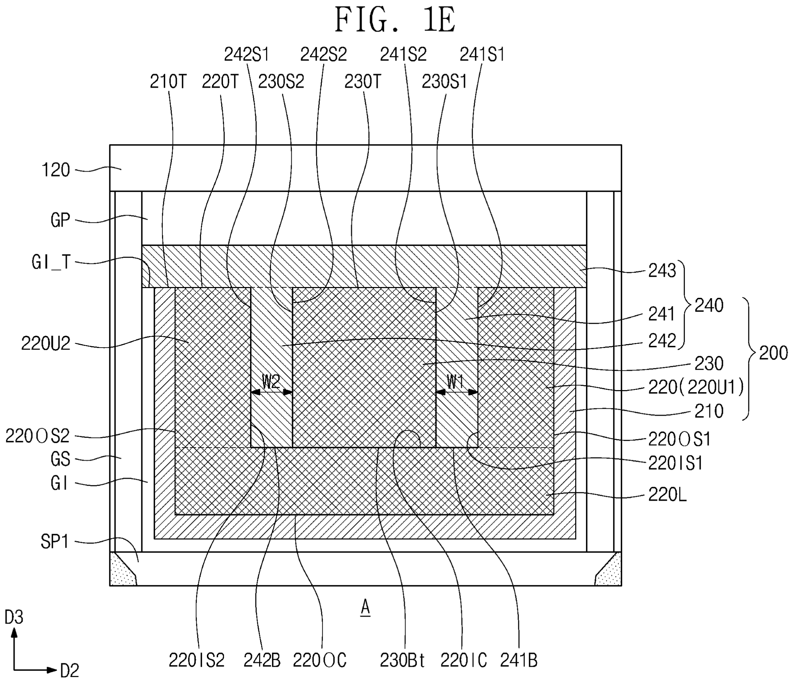

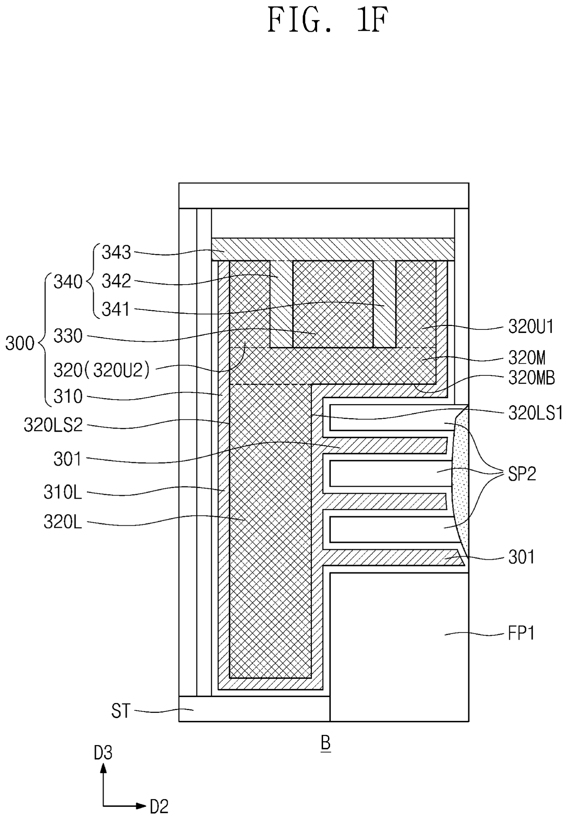

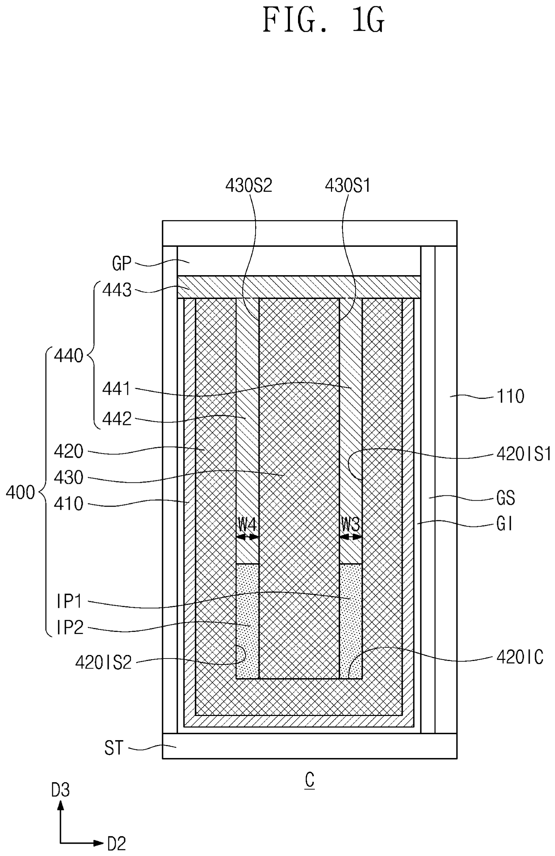

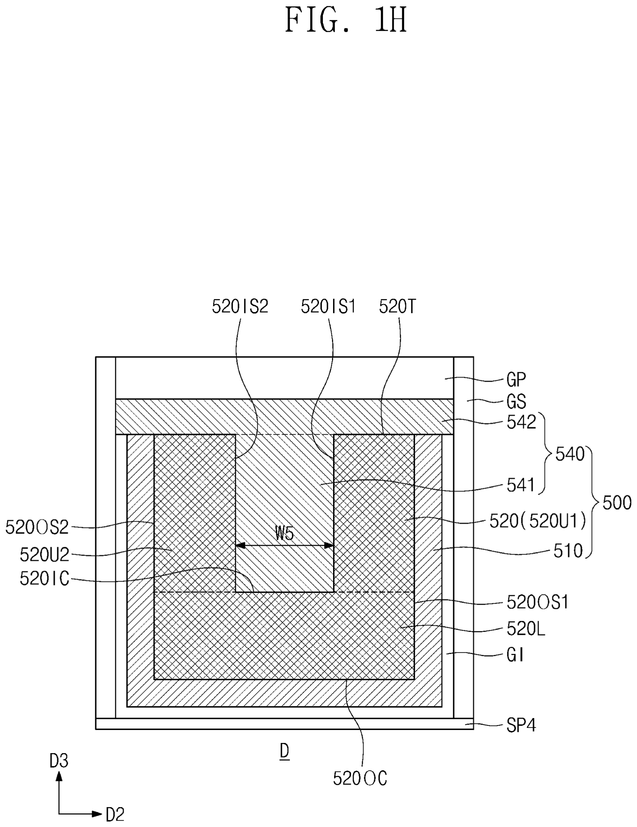

FIG. 1A illustrates a plan view showing a semiconductor device according to one or more embodiments. FIG. 1B illustrates a cross-sectional view taken along line I-I' of FIG. 1A. FIG. 1C illustrates a cross-sectional view taken along line II-II' of FIG. 1A. FIG. 1D illustrates a cross-sectional view taken along line III-III' of FIG. 1A. FIG. 1E illustrates an enlarged view showing section A of FIG. 1B. FIG. 1F illustrates an enlarged view showing section B of FIG. 1B. FIG. 1G illustrates an enlarged view showing section C of FIG. 1B. FIG. 1H illustrates an enlarged view showing section D of FIG. 1D.

Referring to FIGS. 1A, 1B, 1C, and 1D, a substrate 100 may be provided. The substrate 100 may be provided thereon with logic transistors included in a logic circuit. In one or more embodiments, the substrate 100 may be a semiconductor substrate. For example, the substrate 100 may include silicon (Si), germanium (Ge), silicon-germanium (SiGe), gallium phosphide (GaP), or gallium arsenide (GaAs). In one or more embodiments, the substrate 100 may be a silicon-on-insulator (SOI) substrate or a germanium-on-insulator (GOI) substrate. The substrate 100 may have a plate shape that extends along a plane elongated in a first direction D1 and a second direction D2. The first direction D1 and the second direction D2 may intersect each other. For example, the first direction D1 and the second direction D2 may be horizontal directions that are orthogonal to each other.

The substrate 100 may include a first fin pattern FP1 and a second fin pattern FP2. The first and second fin patterns FP1 and FP2 may be defined by a first trench TR1 and a second trench TR2 on the substrate 100. The first and second fin patterns FP1 and FP2 may extend in the second direction D2. The first and second fin patterns FP1 and FP2 may be spaced apart from each other in the first direction D1. The first and second fin patterns FP1 and FP2 may protrude in a third direction D3. The third direction D3 may intersect the first direction D1 and the second direction D2. For example, the third direction D3 may be a vertical direction perpendicular to the first direction D1 and the second direction D2.

The substrate 100 may include a third fin pattern FP3 and a fourth fin pattern FP4. The third and fourth fin patterns FP3 and FP4 may be defined by the first trench TR1 and the second trench TR2 on the substrate 100. The third and fourth fin patterns FP3 and FP4 may extend in the second direction D2. The third and fourth fin patterns FP3 and FP4 may be spaced apart from each other in the first direction D1. The third and fourth fin patterns FP3 and FP4 may protrude in the third direction D3.

A device isolation layer ST may be disposed on the substrate 100. The device isolation layer ST may fill the first and second trenches TR1 and TR2. The device isolation layer ST may include a dielectric material. For example, the device isolation layer ST may include oxide.

First semiconductor patterns SP1 and second semiconductor patterns SP2 may be disposed on the first fin pattern FP1. The first semiconductor patterns SP1 may be spaced apart from each other in the third direction D3. The first semiconductor patterns SP1 may overlap each other in the third direction D3. The second semiconductor patterns SP2 may be spaced apart from each other in the third direction D3. The second semiconductor patterns SP2 may overlap each other in the third direction D3. The first semiconductor pattern SP1 and the second semiconductor pattern SP2 may be spaced apart from each other in the second direction D2. A width in the second direction D2 of the second semiconductor pattern SP2 may be less than a width in the second direction D2 of the first semiconductor pattern SP1.

Third semiconductor patterns SP3 may be disposed on the second fin pattern PF2. The third semiconductor patterns SP3 may be analogous to the first semiconductor patterns SP1. The third semiconductor patterns SP3 may be spaced apart from each other in the third direction D3. The third semiconductor patterns SP3 may be spaced apart in the first direction D1 from the first semiconductor patterns SP1. The first, second, and third semiconductor patterns SP1, SP2, and SP3 may include a semiconductor material. The first, second, and third semiconductor patterns SP1, SP2, and SP3 may serve as channels of transistors.

A plurality of first source/drain patterns SD1 may be disposed on the first fin pattern FP1. In one or more embodiments, the first source/drain patterns SD1 may be impurity regions of a first conductivity type (e.g., p-type).

A plurality of second source/drain patterns may be disposed on the second fin pattern FP2. Except as otherwise described, the second source/drain patterns may be analogous to the first source/drain patterns SD1.

The second source/drain patterns may be impurity regions of a second conductivity type (e.g., n-type). The third semiconductor patterns SP3 may be disposed between the second source/drain patterns that are adjacent to each other in the second direction D2. The third semiconductor patterns SP3 may connect to each other the second source/drain patterns that are adjacent to each other in the second direction D2.

The first source/drain patterns SD1 may be epitaxial patterns formed by a selective epitaxial growth (SEG) process. In one or more embodiments, a top surface of the first source/drain pattern SD1 may be located at a higher level than that of a top surface of the first semiconductor pattern SP1.

A first gate structure 200 may be provided. The first gate structure 200 may overlap in the third direction D3 with the first semiconductor pattern SP1 and the third semiconductor pattern SP3. The first gate structure 200 may extend in the first direction D1. The first gate structure 200 may intersect the first and second fin patterns FP1 and FP2.

A second gate structure 300 may be provided. The second gate structure 300 may overlap in the third direction D3 with the second semiconductor pattern SP2. The second gate structure 300 may be spaced apart in the second direction D2 from the first gate structure 200. The second gate structure 300 may extend in the first direction D1. A thickness in the third direction D3 of the second gate structure 300 may be greater than a thickness in the third direction D3 of the first gate structure 200.

The first gate structure 200 may include a first portion 201 disposed between the first semiconductor patterns SP1 and a second portion 202 disposed between the third semiconductor patterns SP3. The first portion 201 and the second portion 202 of the first gate structure 200 may be portions of an outer conductive layer 210 of the first gate structure 200 which will be discussed below.

The second gate structure 300 may include a first portion 301 disposed between the second semiconductor patterns SP2. The first portion 301 of the second gate structure 300 may be a portion of an outer conductive layer 310 of the second gate structure 300 which will be discussed below.

Third source/drain patterns SD3 may be provided on the third fin pattern FP3. Except as otherwise described, the third source/drain patterns SD3 may be analogous to the first source/drain patterns SD1. Fourth source/drain patterns may be provided on the fourth fin pattern FP4. Except as otherwise described, the fourth source/drain patterns may be analogous to the second source/drain patterns.

Fourth semiconductor patterns SP4 may be disposed on the third fin pattern FP3. The fourth semiconductor patterns SP4 may be analogous to the first semiconductor patterns SP1. The fourth semiconductor patterns SP4 may be disposed between the third source/drain patterns SD3 that are adjacent to each other in the second direction D2. The fourth semiconductor patterns SP4 may connect to each other the third source/drain patterns SD3 that are adjacent to each other in the second direction D2.

A third gate structure 500 may be provided to overlap in the third direction D3 with the fourth semiconductor patterns SP4. Except as otherwise described, the third gate structure 500 may be analogous to the first gate structure 200.

The third gate structure 500 may intersect the third and fourth fin patterns FP3 and FP4. A gate dielectric layer GI, which will be discussed below, may separate the third gate structure 500 and the fourth semiconductor pattern SP4 from each other. The third gate structure 500 may include a first portion 501 disposed between the fourth semiconductor patterns SP4. A thickness in the third direction D3 of the third gate structure 500 may be the same as the thickness in the third direction D3 of the first gate structure 200.

The first gate structure 200 may include an outer conductive layer 210, a first inner conductive layer 220, a second inner conductive layer 230, and a filler conductive layer 240 that are sequentially stacked.

An outer gate structure 400 may be disposed on the device isolation layer ST. The outer gate structure 400 may be spaced apart in the second direction D2 from the first gate structure 200 and the second gate structure 300. The outer gate structure 400 may be spaced apart in the second direction D2 from the first fin pattern FP1 and the second fin pattern FP2. The outer gate structure 400 may be spaced apart in the second direction D2 from the first, second, and third semiconductor patterns SP1, SP2, and SP3. The outer gate structure 400 may not overlap in the third direction D3 with any of the first, second, and third semiconductor patterns SP1, SP2, and SP3. A thickness in the third direction D3 of the outer gate structure 400 may be the same as the thickness in the third direction D3 of the second gate structure 300.

A gate dielectric layer GI may be provided. The gate dielectric layer GI may be disposed between the first gate structure 200 and the first semiconductor pattern SP1, between the second gate structure 300 and the second semiconductor pattern SP2, between the third gate structure 500 and the fourth semiconductor pattern SP4, and/or between the outer gate structure 400 and the device isolation layer ST.

The gate dielectric layer GI may be disposed between the first gate structure 200 and the first fin pattern FP1, between the first gate structure 200 and the second fin pattern FP2, between the second gate structure 300 and the first fin pattern FP1, and between the second gate structure 300 and the second fin pattern FP2. The gate dielectric layer GI may separate the first gate structure 200 and the first semiconductor pattern SP1 from each other. The gate dielectric layer GI may separate the second gate structure 300 and the second semiconductor pattern SP2 from each other. The gate dielectric layer GI may separate the third gate structure 500 and the fourth semiconductor pattern SP4 from each other.

The gate dielectric layer GI may include a dielectric material. For example, the gate dielectric layer GI may include oxide. In one or more embodiments, the gate dielectric layer GI may include a high-k dielectric material having a dielectric constant higher than silicon oxide. For example, the gate dielectric layer GI may include HfO2.

Gate spacers GS may be provided. A pair of gate spacers GS may be disposed on opposite sides of each of the first gate structure 200, the second gate structure 300, the third gate structure 500, and the outer gate structure 400. The gate spacers GS may extend in the first direction D1. The gate spacers GS may have top surfaces coplanar with that of a first interlayer dielectric layer 110 which will be discussed below. The gate spacers GS may include a dielectric material.

Gate capping patterns GP may be provided. The gate capping patterns GP may be disposed on the first gate structure 200, the second gate structure 300, the third gate structure 500, and the outer gate structure 400. The gate capping patterns GP may extend in the first direction D1. The gate capping patterns GP may include a dielectric material.

A first interlayer dielectric layer 110 may be provided. The first interlayer dielectric layer 110 may be disposed on the device isolation layer ST, the gate spacer GS, the first source/drain patterns SD1, and the third source/drain patterns SD3. A second interlayer dielectric layer 120 may be provided on the first interlayer dielectric layer 110. The second interlayer dielectric layer 120 may be disposed on the gate spacer GS, and the gate capping pattern GP. The first and second interlayer dielectric layers 110 and 120 may include a dielectric material. For example, the first and second interlayer dielectric layers 110 and 120 may include oxide. In one or more embodiments, each of the first and second interlayer dielectric layers 110 and 120 may be a multiple dielectric layer including a plurality of dielectric layers.

Active contacts AC may be provided to penetrate the first and second interlayer dielectric layers 110 and 120. The active contact AC may be electrically connected to the first source/drain pattern SD1 or the second source/drain pattern. The active contact AC may include a conductive pattern FM and a barrier pattern BM that surrounds the conductive pattern FM. For example, the conductive pattern FM may include at least one metal selected from aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer. A silicide pattern may be interposed between the active contact AC and the first source/drain pattern SD1 and/or between the active contact AC and the third source/drain pattern SD3.

Gate contacts GC may be provided. The gate contact GC may be electrically connected to the first gate structure 200 or the second gate structure 300. Similar to the active contact AC, the gate contact GC may include a conductive pattern FM and a barrier pattern BM that surrounds the conductive pattern FM.

A third interlayer dielectric layer 130 may be provided on the second interlayer dielectric layer 120. A fourth interlayer dielectric layer 140 may be provided on the third interlayer dielectric layer 130. The third and fourth interlayer dielectric layers 130 and 140 may include a dielectric material. A first wiring structure M1 may be provided in the third interlayer dielectric layer 130. The first wiring structure M1 may include a conductive material. The first wiring structure M1 may include a plurality of vias and a plurality of lines. A second wiring structure M2 may be provided in the fourth interlayer dielectric layer 140. The second wiring structure M2 may include a conductive material. The second wiring structure M2 may include a plurality of vias and a plurality of lines.

Referring to FIG. 1E, the first gate structure 200 may include an outer conductive layer 210, a first inner conductive layer 220, a second inner conductive layer 230, and a filler conductive layer 240.

The outer conductive layer 210 may be disposed on the gate dielectric layer GI. The outer conductive layer 210 may be in contact with the gate dielectric layer GI. The gate dielectric layer GI may cause a separation in the third direction D3 between the outer conductive layer 210 and the first semiconductor pattern SP1. The outer conductive layer 210 may be disposed in or surrounded by the gate dielectric layer GI.

The first inner conductive layer 220 may be disposed on the outer conductive layer 210. The first inner conductive layer 220 may be spaced apart from the gate dielectric layer GI across the outer conductive layer 210. The first inner conductive layer 220 may have a first outer sidewall 220OS1, a second outer sidewall 220OS2, a first inner sidewall 220IS1, a second inner sidewall 220IS2, an inner connection surface 220IC, and an outer connection surface 220OC.

The first outer sidewall 220OS1 and the second outer sidewall 220OS2 of the first inner conductive layer 220 may be opposite to each other. The outer connection surface 220OC of the first inner conductive layer 220 may connect to each other the first outer sidewall 220OS1 and the second outer sidewall 220OS2. The first outer sidewall 220OS1, the second outer sidewall 220OS2, and the outer connection surface 220OC of the first inner conductive layer 220 may be in contact with the outer conductive layer 210. The inner connection surface 220IC of the first inner conductive layer 220 may connect to each other the first inner sidewall 220IS1 and the second inner sidewall 220IS2. A recess may be defined by the first inner sidewall 220IS1, the second inner sidewall 220IS2, and the inner connection surface 220IC of the first inner conductive layer 220. The inner connection surface 220IC of the first inner conductive layer 220 may be located at a lower level than that of a top surface 220T of the first inner conductive layer 220. A top surface 210T of the outer conductive layer 210 may be coplanar with the top surface 220T of the first inner conductive layer 220.

The first inner conductive layer 220 may include a lower portion 220L, and may also include a first upper portion 220U1 and a second upper portion 220U2 that are located at a higher level than that of the lower portion 220L. A top surface of the lower portion 220L of the first inner conductive layer 220 may be the inner connection surface 220IC of the first inner conductive layer 220. The first upper portion 220U1 and the second upper portion 220U2 of the first inner conductive layer 220 may be located at a higher level than that of the inner connection surface 220IC.

The second inner conductive layer 230 may be disposed on the inner connection surface 220IC of the first inner conductive layer 220. The second inner conductive layer 230 may be disposed in or surrounded by the first inner conductive layer 220. The second inner conductive layer 230 may have a bar shape that extends in the first direction D1.

A bottom surface 230Bt of the second inner conductive layer 230 may be in contact with the inner connection surface 220IC of the first inner conductive layer 220. The second inner conductive layer 230 may be spaced apart in the second direction D2 from the first inner sidewall 220IS1 and the second inner sidewall 220IS2 of the first inner conductive layer 220. The second inner conductive layer 230 may be spaced apart in the second direction D2 from the outer conductive layer 210 across the first inner conductive layer 220.

The second inner conductive layer 230 may have a first sidewall 230S1 and a second sidewall 230S2 that are opposite to each other. The first sidewall 230S1 of the second inner conductive layer 230 may stand opposite to the first inner sidewall 220IS1 of the first inner conductive layer 220. The second sidewall 230S2 of the second inner conductive layer 230 may stand opposite to the second inner sidewall 220IS2 of the first inner conductive layer 220.

A length in the third direction D3 of the first sidewall 230S1 and the second sidewall 230S2 of the second inner conductive layer 230 may be the same as a length in the third direction D3 of the first inner sidewall 220IS1 and the second inner sidewall 220IS2 of the first inner conductive layer 220. A top surface 230T of the second inner conductive layer 230 may be located at the same level as that of the top surface 220T of the first inner conductive layer 220. A thickness in the third direction D3 of the second inner conductive layer 230 may be the same as a thickness in the third direction D3 of the first and second upper portions 220U1 and 220U2 of the first inner conductive layer 220.

The filler conductive layer 240 may be disposed on the first inner conductive layer 220 and the second inner conductive layer 230. The filler conductive layer 240 may include a first portion 241 in contact with the first inner sidewall 220IS1 and the inner connection surface 220IC of the first inner conductive layer 220 and with the first sidewall 230S1 of the second inner conductive layer 230. The filler conductive layer 240 may include a second portion 242 in contact with the second inner sidewall 220IS2 and the inner connection surface 220IC of the first inner conductive layer 220 and with the second sidewall 230S2 of the second inner conductive layer 230.

The filler conductive layer 240 may include a third portion 243 that covers a top surface GI_T of the gate dielectric layer GI, the top surface 210T of the outer conductive layer 210, the top surface 220T of the first inner conductive layer 220, and the top surface 230T of the second inner conductive layer 230. In one or more embodiments, the filler conductive layer 240 may not include the third portion 243, and the gate capping pattern GP may contact the outer conductive layer 210, the first inner conductive layer 220, and the second inner conductive layer 230.

The first portion 241 and the second portion 242 of the filler conductive layer 240 may be disposed in or surrounded by the first inner conductive layer 220. The first portion 241 of the filler conductive layer 240 may have a first sidewall 241S1 in contact with the first inner sidewall 220IS1 of the first inner conductive layer 220. The first portion 241 of the filler conductive layer 240 may also have a second sidewall 241S2 in contact with the first sidewall 230S1 of the second inner conductive layer 230. The filler conductive layer 240 may be configured such that the first sidewall 241S1 and the second sidewall 241 S2 of the first portion 241 are opposite to each other in the second direction D2.

The second portion 242 of the filler conductive layer 240 may have a first sidewall 242S1 in contact with the second inner sidewall 220IS2 of the first inner conductive layer 220. The second portion 242 of the filler conductive layer 240 may also have a second sidewall 242S2 in contact with the second sidewall 230S2 of the second inner conductive layer 230. The filler conductive layer 240 may be configured such that the first sidewall 242S1 and the second sidewall 242S2 of the second portion 242 are opposite to each other in the second direction D2.

The first portion 241 of the filler conductive layer 240 may cause a separation in the second direction D2 between the second inner conductive layer 230 and the first upper portion 220U1 of the first inner conductive layer 220. The second portion 242 of the filler conductive layer 240 may cause a separation in the second direction D2 between the second inner conductive layer 230 and the second upper portion 220U2 of the first inner conductive layer 220.

A bottom surface 241B of the first portion 241 and a bottom surface 242B of the second portion 242 of the filler conductive layer 240 may be in contact with the inner connection surface 220IC of the first inner conductive layer 220. A coplanar relationship may be achieved between the bottom surface 241B of the first portion 241 of the filler conductive layer 240, the bottom surface 242B of the second portion 242 of the filler conductive layer 240, and the bottom surface 230Bt of the second inner conductive layer 230.

The first portion 241 and the second portion 242 of the filler conductive layer 240 may be spaced apart in the second direction D2 from each other across the second inner conductive layer 230. In the filler conductive layer 240, a width W1 in the second direction D2 of the first portion 241 may be the same as a width W2 in the second direction D2 of the second portion 242.

The third portion 243 of the filler conductive layer 240 may connect to each other the first portion 241 and the second portion 242 of the filler conductive layer 240. The third portion 243 of the filler conductive layer 240 may be in contact with a bottom surface of the gate capping pattern GP. The third portion 243 of the filler conductive layer 240 may be in contact with a sidewall of the gate spacer GS.

A conductive material may be included in the outer conductive layer 210, the first inner conductive layer 220, the second inner conductive layer 230, and the filler conductive layer 240. The first inner conductive layer 220 and the second inner conductive layer 230 may include the same first conductive material. The filler conductive layer 240 may include a second conductive material different from the first conductive material. In one or more embodiments, the outer conductive layer 210 may include the first conductive material. The second conductive material may include a material whose resistivity is less than that of the first conductive material. For example, the outer conductive layer 210, the first inner conductive layer 220, and the second inner conductive layer 230 may include titanium nitride (TiN), and the filler conductive layer 240 may include tungsten (W). In one or more embodiments, the outer conductive layer 210 may include a third conductive material different from the first conductive material and the second conductive material. In one or more embodiments, the first inner conductive layer 220 may be a multiple layer including a plurality of conductive layers.

Referring to FIG. 1F, the second gate structure 300 may include an outer conductive layer 310, a first inner conductive layer 320, a second inner conductive layer 330, and a filler conductive layer 340. The filler conductive layer 340 of the second gate structure 300 may include a first portion 341, a second portion 342, and a third portion 343. Except as otherwise described, the second gate structure 300 may be analogous to the first gate structure 200.

The outer conductive layer 310 of the second gate structure 300 may include a lower portion 310L. The second gate structure 300 may be configured such that the lower portion 310L of the outer conductive layer 310 includes the first portion 301 of the second gate structure 300.

The first inner conductive layer 320 of the second gate structure 300 may include a lower portion 320L, a middle portion 320M, a first upper portion 320U1, and a second upper portion 320U2. The middle portion 320M of the first inner conductive layer 320 of the second gate structure 300 may be analogous to the lower portion 220L of the first inner conductive layer 220 of the first gate structure 200.

In the second gate structure 300, the lower portion 310L of the outer conductive layer 310 may be located at a lower level than that of the middle portion 320M of the first inner conductive layer 320. In the second gate structure 300, the lower portion 310L of the outer conductive layer 310 may be in contact with a bottom surface 320MB of the middle portion 320M of the first inner conductive layer 320. The bottom surface 320MB of the middle portion 320M of the first inner conductive layer 320 may be connected to a first sidewall 320LS1 of the lower portion 320L of the first inner conductive layer 320. The bottom surface 320MB of the middle portion 320M of the first inner conductive layer 320 may be spaced apart in the second direction D2 from a second sidewall 320LS2 of the lower portion 320L of the first inner conductive layer 320.

The lower portion 320L of the first inner conductive layer 320 of the second gate structure 300 may overlap in the second direction D2 with the second semiconductor patterns SP2, the first source/drain pattern SD1, and the first fin pattern FP1. The lower portion 320L of the first inner conductive layer 320 may be spaced apart in the second direction D2 from the first fin pattern FP1 and the second semiconductor patterns SP2. The first portion 301 of the second gate structure 300 may be disposed between the second semiconductor patterns SP2 and the lower portion 320L of the first inner conductive layer 320. In the second gate structure 300, the lower portion 320L of the first inner conductive layer 320 may be disposed in or surrounded by the lower portion 310L of the outer conductive layer 310.

Referring to FIG. 1G, the outer gate structure 400 may include an outer conductive layer 410, a first inner conductive layer 420, a second inner conductive layer 430, a filler conductive layer 440, a first dielectric pattern IP1, and a second dielectric pattern IP2. The filler conductive layer 440 of the outer gate structure 400 may include a first portion 441, a second portion 442, and a third portion 443. Except as otherwise described, the outer gate structure 400 may be analogous to the first gate structure 200.

The first portion 441 of the filler conductive layer 440 of the outer gate structure 400 may be disposed on the first dielectric pattern IP1. The second portion 442 of the filler conductive layer 440 may be disposed on the second dielectric pattern IP2. The first dielectric pattern IP1 and the second dielectric pattern IP2 may be disposed in or surrounded by the outer conductive layer 410. The first dielectric pattern IP1 and the second dielectric pattern IP2 may be disposed in or surrounded by the first inner conductive layer 420. The first dielectric pattern IP1 and the second dielectric pattern IP2 may be spaced apart from the outer conductive layer 410 across the first inner conductive layer 420. The first dielectric pattern IP1 and the second dielectric pattern IP2 may be spaced apart in the second direction D2 from each other across the second inner conductive layer 430. A thickness in the third direction D3 of the first and second dielectric patterns IP1 and IP2 may be less than a thickness in the third direction D3 of the second inner conductive layer 430. When viewed in cross-section as illustrated in FIG. 1G, the first dielectric pattern IP1 may be enclosed by the first inner conductive layer 420, the second inner conductive layer 430, and the first portion 441 of the filler conductive layer 440. When viewed in cross-section as illustrated in FIG. 1G, the second dielectric pattern IP2 may be enclosed by the first inner conductive layer 420, the second inner conductive layer 430, and the second portion 442 of the filler conductive layer 440.

The first dielectric pattern IP1 may be in contact with a first inner sidewall 420IS1 and an inner connection surface 420IC of the first inner conductive layer 420 and with a first sidewall 430S1 of the second inner conductive layer 430. The second dielectric pattern IP2 may be in contact with a second inner sidewall 420IS2 and the inner connection surface 420IC of the first inner conductive layer 420 and with a second sidewall 430S2 of the second inner conductive layer 430.

A sidewall of the first dielectric pattern IP1 may be coplanar with a sidewall of the first portion 441 of the filler conductive layer 440. A sidewall of the second dielectric pattern IP2 may be coplanar with a sidewall of the second portion 442 of the filler conductive layer 440. A width W3 in the second direction D2 of the first dielectric pattern IP1 may be the same as a width W3 in the second direction D2 of the first portion 441 of the filler conductive layer 440. A width W4 in the second direction D2 of the second dielectric pattern IP2 may be the same as a width W4 in the second direction D2 of the second portion 442 of the filler conductive layer 440. The width W3 in the second direction D2 of the first dielectric pattern IP1 may be the same as the width W4 in the second direction D2 of the second dielectric pattern IP2. The width W3 in the second direction D2 of the first dielectric pattern IP1, the width W4 in the second direction D2 of the second dielectric pattern IP2, the width W1 in the second direction D2 of the first portion 241 of the filler conductive layer 240, and the width W2 in the second direction D2 of the second portion 242 of the filler conductive layer 240 may be the same as each other.

The first dielectric pattern IP1 and the second dielectric pattern IP2 may include, for example, polysilicon, SiO₂, SiN, H₃PO₄, or HF.

Referring to FIG. 1H, the third gate structure 500 may include an outer conductive layer 510, an inner conductive layer 520, and a filler conductive layer 540. The filler conductive layer 540 of the third gate structure 500 may include a first portion 541 and a second portion 542 on the first portion 541. In one or more embodiments, the filler conductive layer 540 may not include the second portion 542, and the gate capping pattern GP may be in contact with the outer conductive layer 510 and the inner conductive layer 520. Except as otherwise described, the third gate structure 500 may be analogous to the first gate structure 200.

The inner conductive layer 520 of the third gate structure 500 may be disposed in or surrounded by the outer conductive layer 510. The inner conductive layer 520 of the third gate structure 500 may have a first outer sidewall 520OS1, a second outer sidewall 520OS2, and an outer connection surface 520OC that are in contact with the outer conductive layer 510. The first portion 541 of the filler conductive layer 540 may be disposed in or surrounded by the outer conductive layer 510. The first portion 541 of the filler conductive layer 540 may be disposed in or surrounded by the inner conductive layer 520. The inner conductive layer 520 may separate the filler conductive layer 540 from the outer conductive layer 510. The first portion 541 of the filler conductive layer 540 may be located at a lower level than that of a top surface 520T of the inner conductive layer 520.

The first portion 541 of the filler conductive layer 540 may be in contact with a first inner sidewall 520IS1, a second inner sidewall 520IS2, and an inner connection surface 520IC of the inner conductive layer 520. A width W5 in the second direction D2 of the first portion 541 of the filler conductive layer 540 in the third gate structure 500 may be greater than the width W1 in the second direction D2 of the first portion 241 of the filler conductive layer 240 in the first gate structure 200 and greater than the width W2 in the second direction D2 of the second portion 242 of the filler conductive layer 240 in the first gate structure 200. A width W5 in the second direction D2 of the first portion 541 of the filler conductive layer 540 in the third gate structure 500 may be less than twice the width W1 in the second direction D2 of the first portion 241 of the filler conductive layer 240 in the first gate structure 200.

The inner conductive layer 520 may include a first upper portion 520U1 and a second upper portion 520U2 that are spaced apart from each other across the first portion 541 of the filler conductive layer 540. The inner conductive layer 520 may include a lower portion 520L that connects to each other the first upper portion 520U1 and the second upper portion 520U2.

The second portion 542 of the filler conductive layer 540 may cover a top surface of the gate dielectric layer GI, a top surface of the outer conductive layer 510, and a top surface of the inner conductive layer 520. The second portion 542 of the filler conductive layer 540 may be in contact with the gate spacer GS.

The same material may be included in the outer conductive layer 210 of the first gate structure 200, the outer conductive layer 310 of the second gate structure 300, the outer conductive layer 410 of the outer gate structure 400, and the outer conductive layer 510 of the third gate structure 500. The same material may be included in the first and second inner conductive layers 220 and 230 of the first gate structure 200, the first and second inner conductive layers 320 and 330 of the second gate structure 300, the first and second inner conductive layers 420 and 430 of the outer gate structure 400, and the inner conductive layer 520 of the third gate structure 500. The same material may be included in the filler conductive layer 240 of the first gate structure 200, the filler conductive layer 340 of the second gate structure 300, the filler conductive layer 440 of the outer gate structure 400, and the filler conductive layer 540 of the third gate structure 500.

A semiconductor device according to one or more embodiments may include the filler conductive layer 240 disposed between the first inner conductive layer 220 and the second inner conductive layer 230 of the first gate structure 200. Therefore, during the formation of the first gate structure 200 having a relatively large width, the first gate structure 200 may be prevented from being excessively etched at an upper portion thereof.

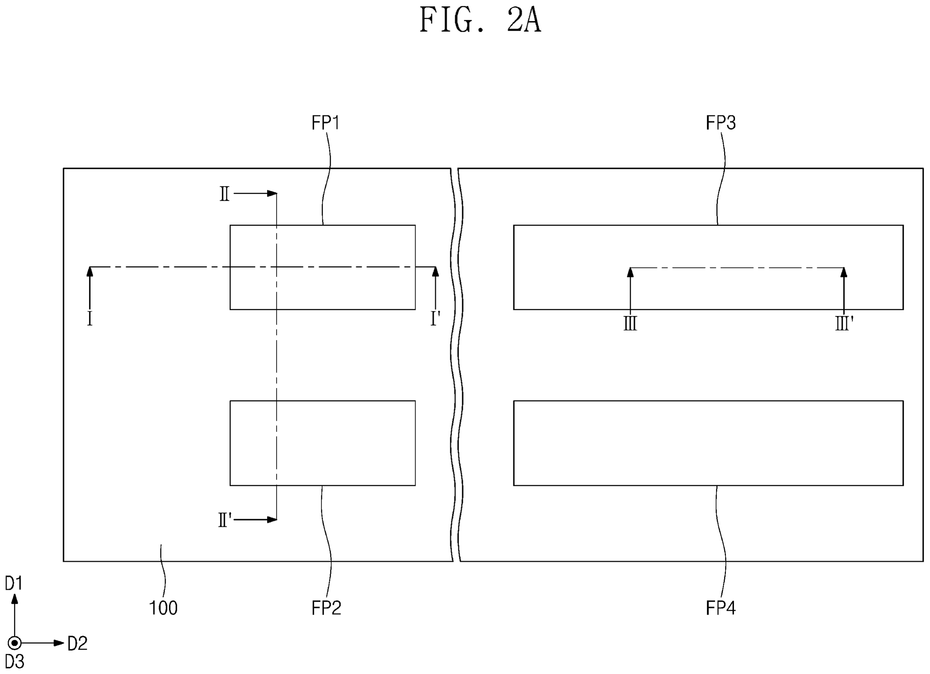

FIGS. 2A, 2B, 2C, 2D, 3A, 3B, 3C, 3D, 4A, 4B, 4C, 5A, 5B, 5C, 5D, 6A, 6B, 6C, 7A, 7B, 7C, 8A, 8B, 8C, 9A, 9B, 9C, 9D, 10A, 10B, 10C, 11A, 11B, 11C, 12A, 12B, 12C, 13A, 13B, 13C, 14A, 14B, 14C, 15A, 15B, and 15C illustrate diagrams showing a method of fabricating a semiconductor device in accordance with FIGS. 1A to 1H.

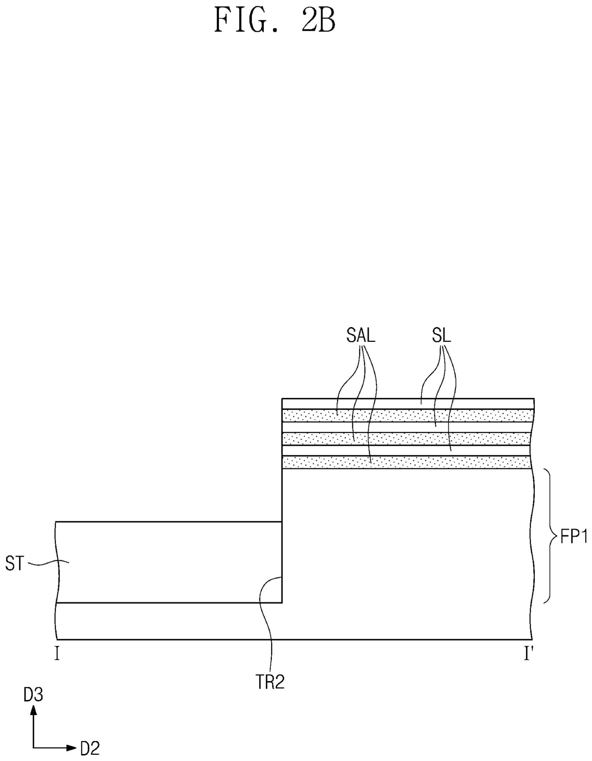

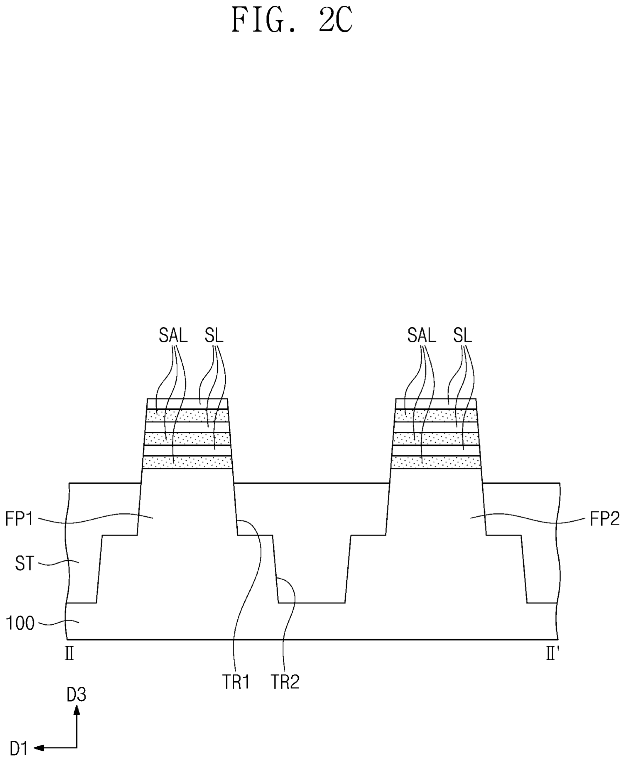

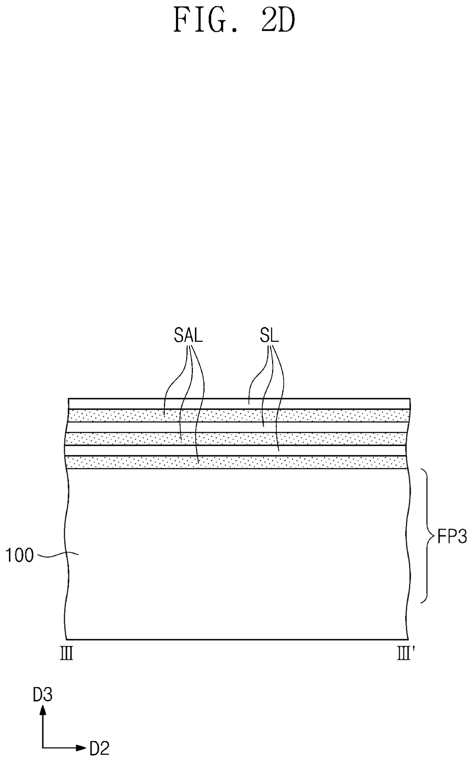

Referring to FIGS. 2A, 2B, 2C, and 2D, a substrate 100 may be provided. Semiconductor layers SL and sacrificial layers SAL may be formed alternately stacked on the substrate 100. The semiconductor layers SL may include a semiconductor material. The sacrificial layers SAL may include a material having an etch selectivity with respect to the semiconductor layers SL. For example, the semiconductor layers SL may include Si, and the sacrificial layers SAL may include SiGe.

The substrate 100 may be patterned to form first, second, third, and fourth fin patterns FP1, FP2, FP3, and FP4. The patterning of the substrate 100 may include forming a first trench TR1 and a second trench TR2. When the substrate 100 is patterned, the sacrificial layers SAL and the semiconductor layers SL may also be patterned. A device isolation layer ST may be formed to fill the first trench TR1 and the second trench TR2.

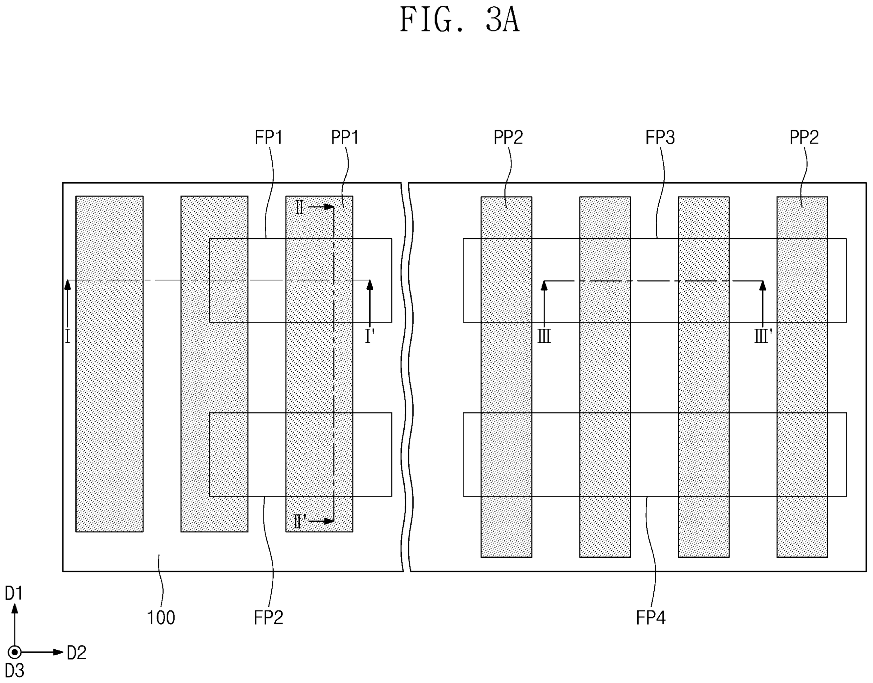

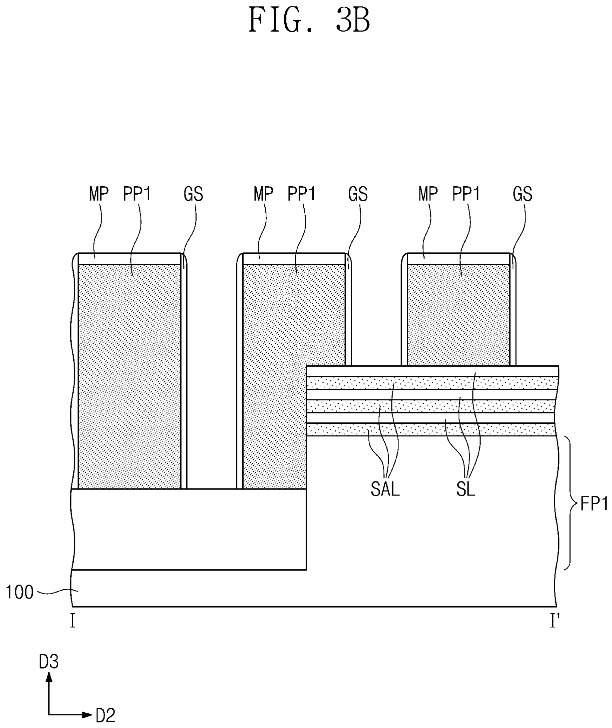

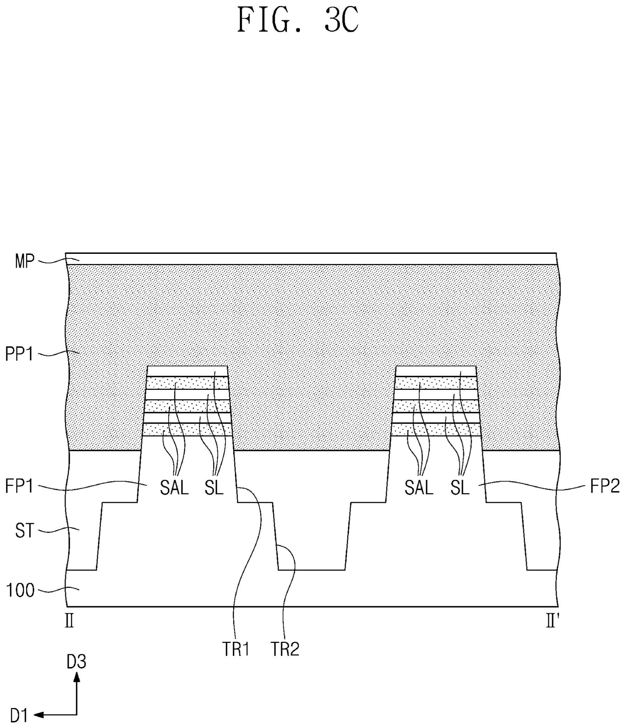

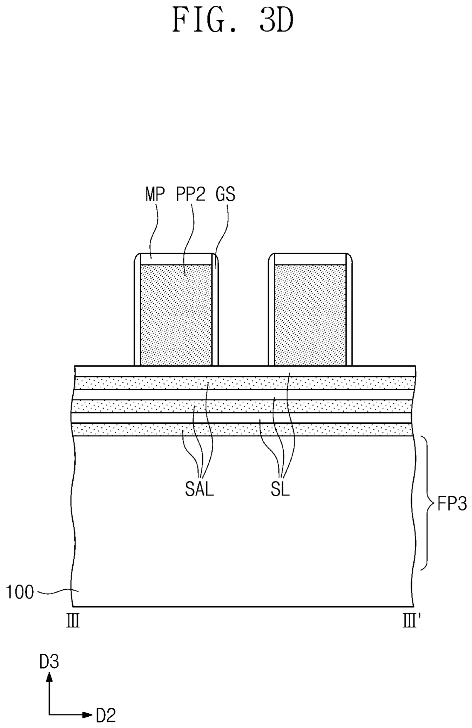

Referring to FIGS. 3A, 3B, 3C, and 3D, first sacrificial patterns PP1 may be formed which extend in a first direction D1 and are spaced apart from each other in a second direction D2. Second sacrificial patterns PP2 may be formed which extend in the first direction D1 and are spaced apart from each other in the second direction D2. One or more of the first sacrificial patterns PP1 may intersect the first fin pattern FP1 and the second fin pattern FP2. One or more of the first sacrificial patterns PP1 may not overlap any of the first fin pattern FP1 and the second fin pattern FP2. The second sacrificial patterns PP2 may intersect the third fin pattern FP3 and the fourth fin pattern FP4.

A width in the second direction D2 of the first sacrificial pattern PP1 may be greater than a width in the second direction D2 of the second sacrificial pattern PP2.

The formation of the first sacrificial patterns PP1 and the second sacrificial patterns PP2 may include forming a sacrificial structure to cover the substrate 100, forming hardmask patterns MP on the sacrificial pattern, and using the hardmask patterns MP as an etching mask to pattern the sacrificial structure.

A gate spacer GS may be formed on each of sidewalls of the first sacrificial pattern PP1 and each of sidewalls of the second sacrificial pattern PP2.

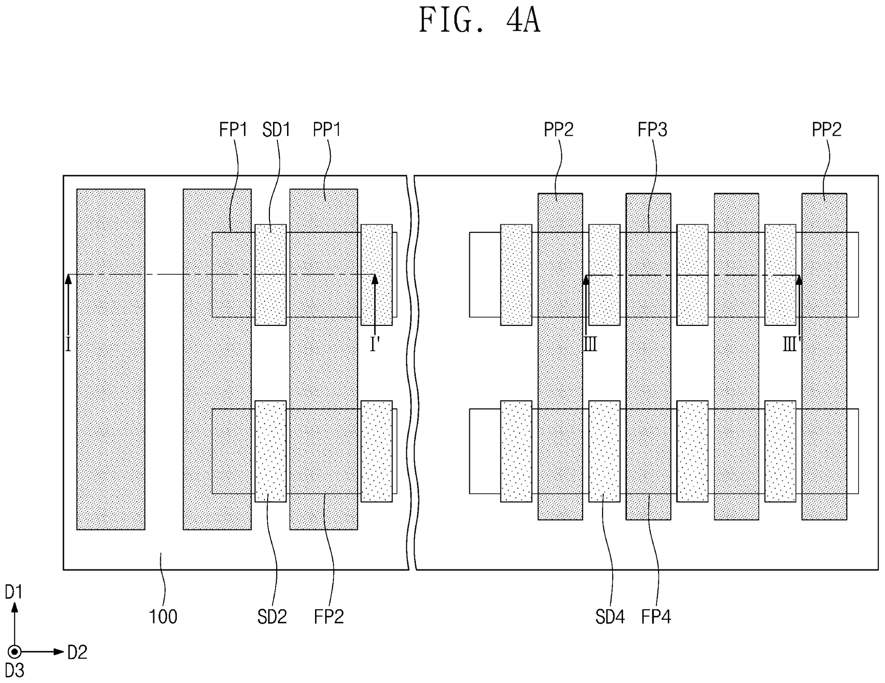

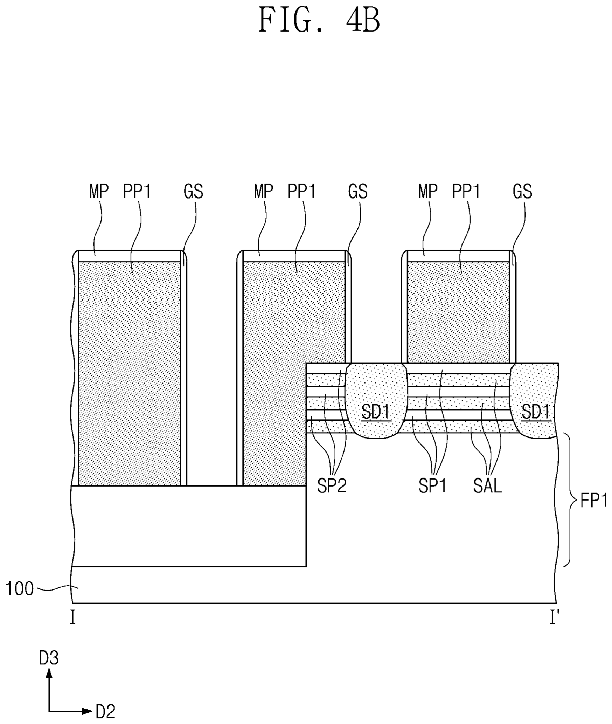

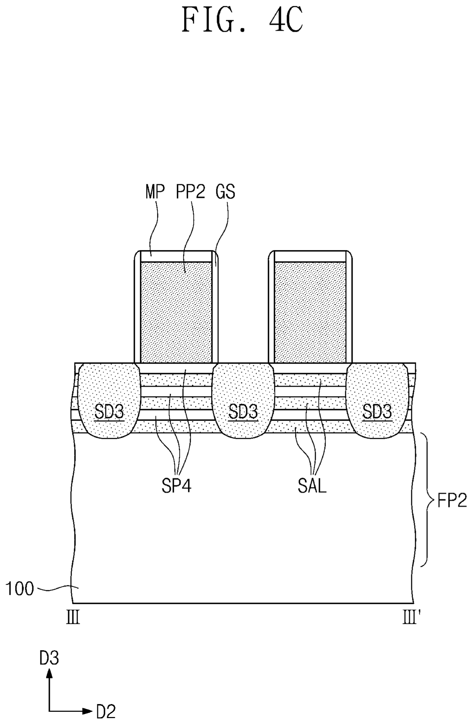

Referring to FIGS. 4A, 4B, and 4C, there may be formed first source/drain patterns SD1, second source/drain patterns SD2, third source/drain patterns SD3, and fourth source/drain patterns SD4. The formation of the first, second, third, and fourth source/drain patterns SD1, SD2, SD3, and SD4 may include using the hardmask patterns MP and the gate spacers GS as an etching mask to etch the sacrificial layer SAL, the semiconductor layer SL, and the first, second, third, and fourth fin patterns FP1, FP2, FP3, and FP4. The formation of the first, second, third, and fourth source/drain patterns SD1, SD2, SD3, and SD4 may include performing a selective epitaxial growth process in which sidewalls of the etched semiconductor layer SL and sidewalls of the etched first, second, third, and fourth fin patterns FP1, FP2, FP3, and FP4 are used seed layers.

The semiconductor layer SL may be etched to define a first semiconductor pattern SP1, a second semiconductor pattern SP2, a third semiconductor pattern SP3, and a fourth semiconductor pattern SP4.

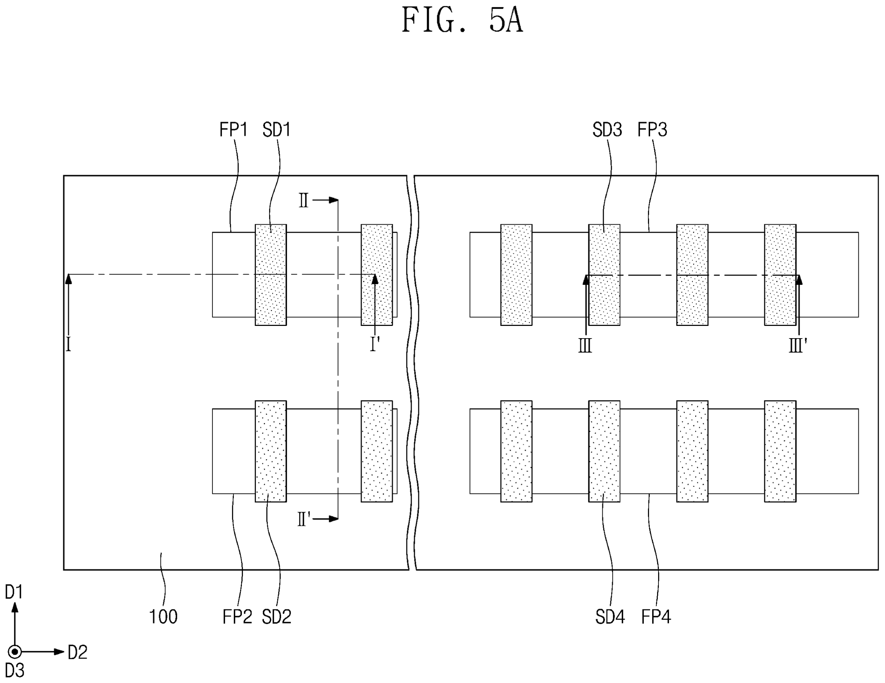

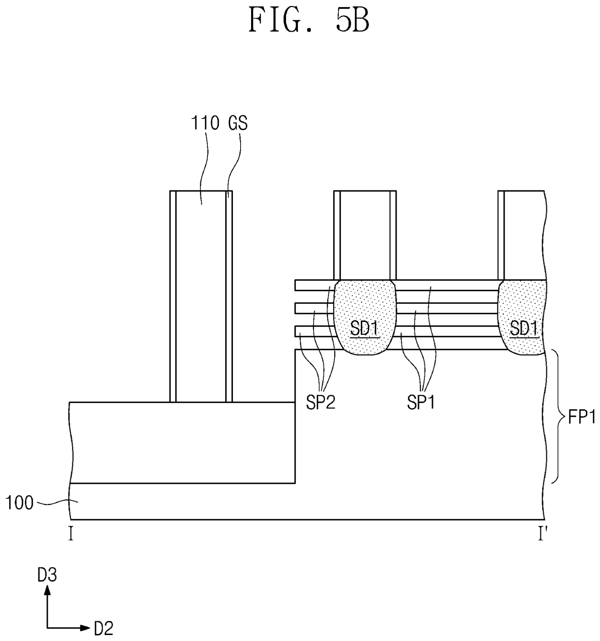

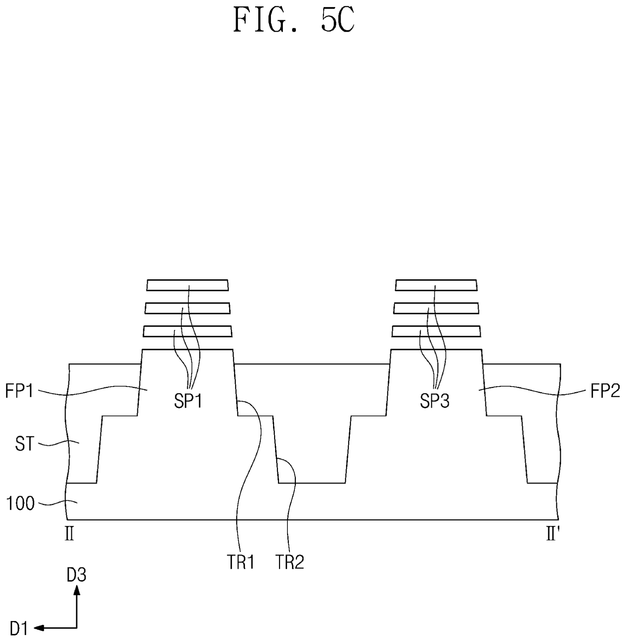

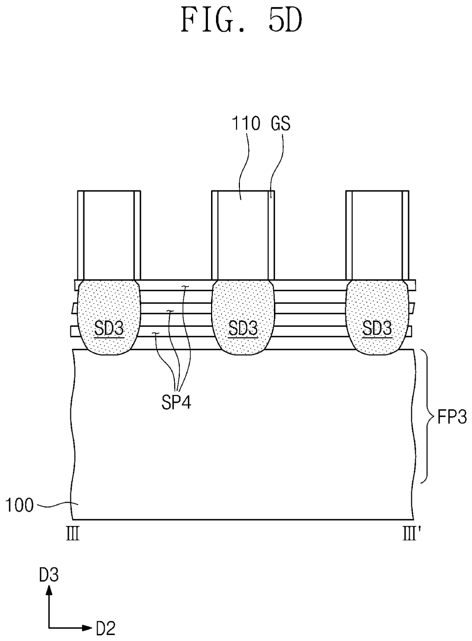

Referring to FIGS. 5A, 5B, 5C, and 5D, a first interlayer dielectric layer 110 may be formed to cover the first, second, third, and fourth source/drain patterns SD1, SD2, SD3, and SD4, the hardmask patterns MP, and the gate spacers GS. The hardmask patterns MP and a portion of the first interlayer dielectric layer 110 may be removed to expose top surfaces of the first and second sacrificial patterns PP1 and PP2. The partial removal of the first interlayer dielectric layer 110 may include, for example, performing an etch-back process or a chemical mechanical polishing (CMP) process. The first interlayer dielectric layer 110, the first sacrificial pattern PP1, the second sacrificial pattern PP2, and the gate spacer GS may have top surfaces coplanar with each other.

The first and second sacrificial patterns PP1 and PP2 may be removed. The removal of the first and second sacrificial patterns PP1 and PP2 may expose the first, second, third, and fourth semiconductor patterns SP1, SP2, SP3, and SP4.

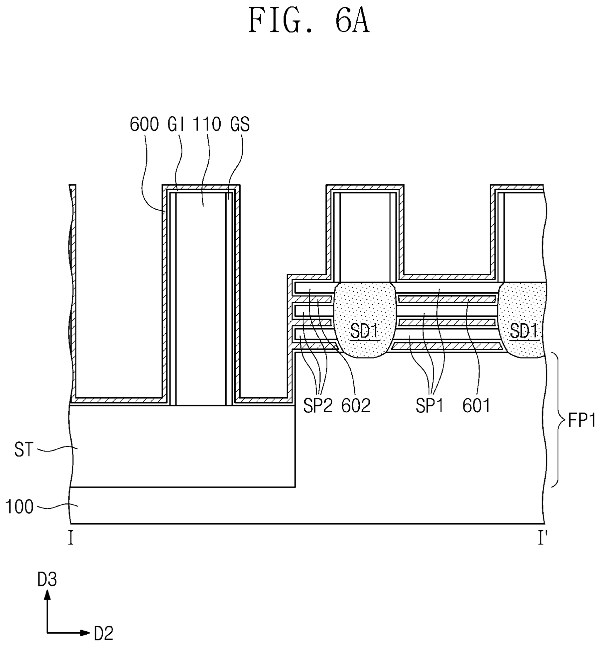

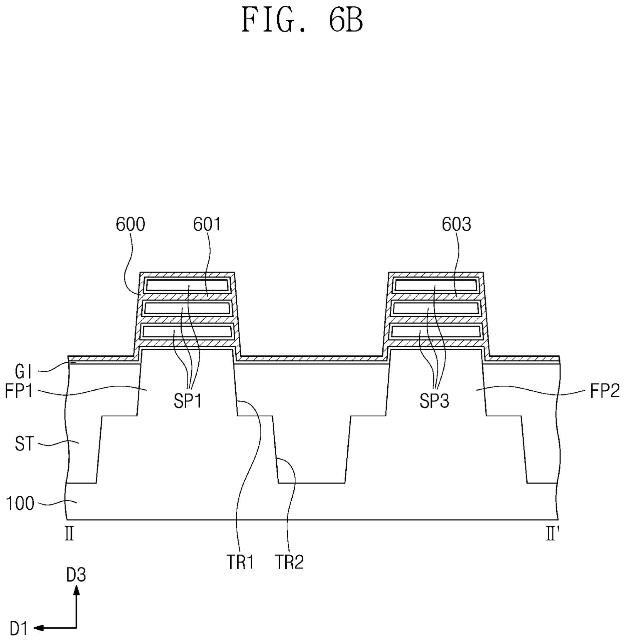

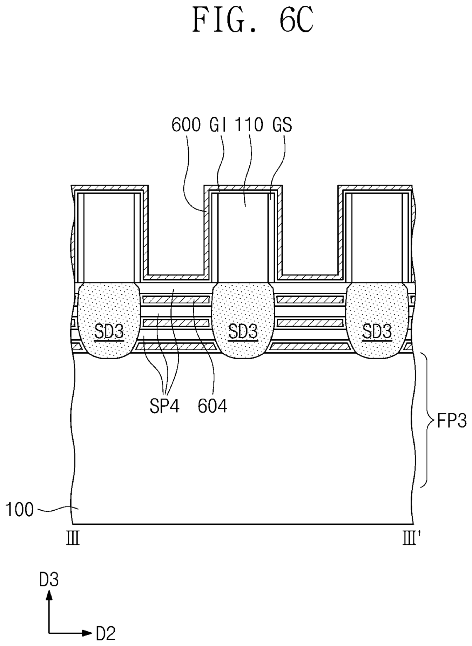

Referring to FIGS. 6A, 6B, and 6C, a gate dielectric layer GI may be formed. The gate dielectric layer GI may be formed on the first, second, third, and fourth fin patterns FP1, FP2, FP3, and FP4 and on the first, second, third, and fourth semiconductor patterns SP1, SP2, SP3, and SP4.

A first preliminary conductive layer 600 may be formed on the gate dielectric layer GI. The first preliminary conductive layer 600 may include a conductive material. For example, the first preliminary conductive layer 600 may include TiN. The first preliminary conductive layer 600 may conformally cover the gate spacer GS, the gate dielectric layer GI, and the first interlayer dielectric layer 110. The first preliminary conductive layer 600 may include a first portion 601 disposed between the first semiconductor patterns SP1, a second portion 602 disposed between the second semiconductor patterns SP2, a third portion 603 disposed between the third semiconductor patterns SP3, and a fourth portion 604 disposed between the fourth semiconductor patterns SP4.

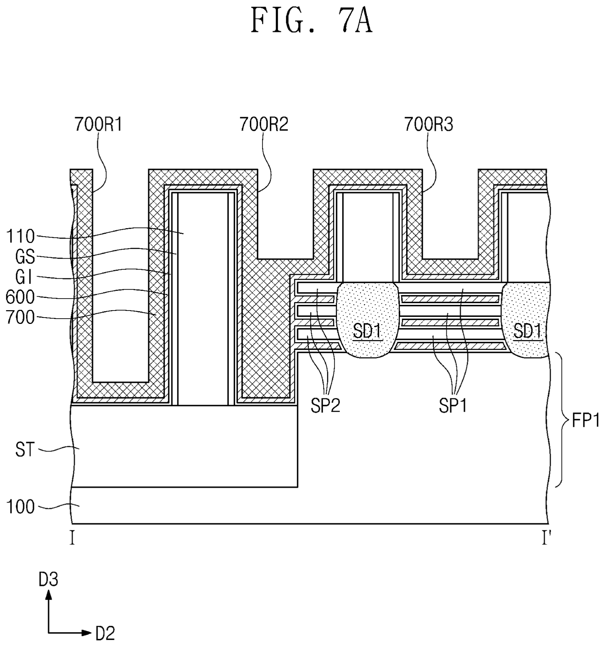

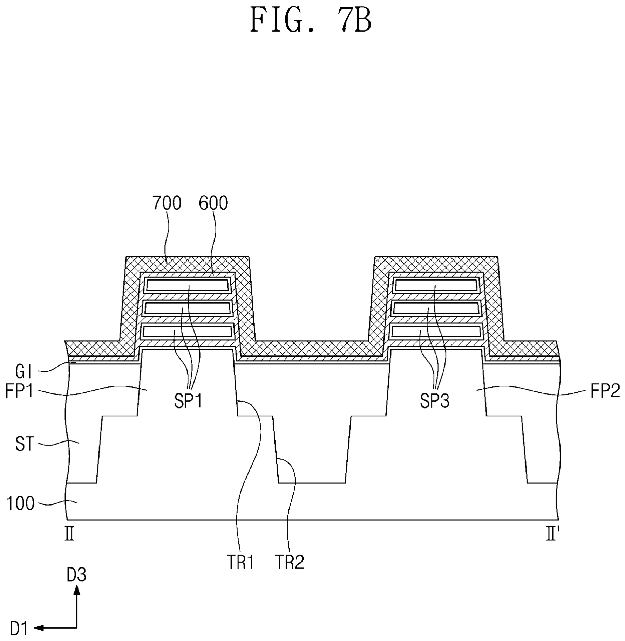

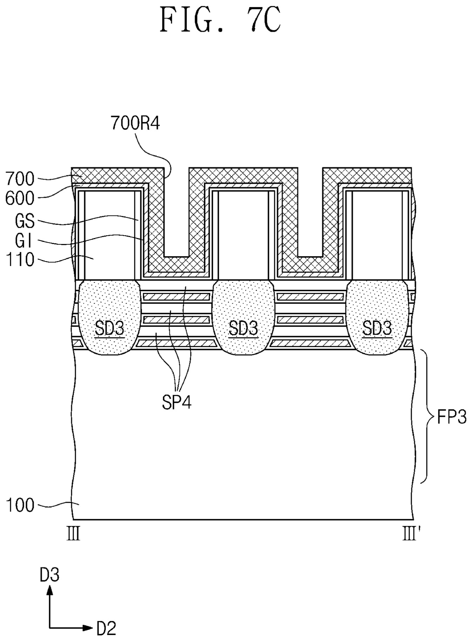

Referring to FIGS. 7A, 7B, and 7C, a second preliminary conductive layer 700 may be formed to cover the first preliminary conductive layer 600. The second preliminary conductive layer 700 may include a conductive material. For example, the second preliminary conductive layer 700 may include TiN.

The second preliminary conductive layer 700 may conformally cover the first preliminary conductive layer 600. The second preliminary conductive layer 700 may not be disposed between the first semiconductor patterns SP1, between the second semiconductor patterns SP2, between the third semiconductor patterns SP3, or between the fourth semiconductor patterns SP4.

A top surface of the second preliminary conductive layer 700 may define a first recess 700R1 spaced apart in the second direction D2 from the first fin pattern FP1, a second recess 700R2 spaced apart in a third direction D3 from the second semiconductor pattern SP2, a third recess 700R3 that overlaps in the third direction D3 with the first semiconductor pattern SP1, and a fourth recess 700R4 that overlaps in the third direction D3 with the fourth semiconductor pattern SP4. A width in the second direction D2 of the fourth recess 700R4 may be less than a width in the second direction D2 of the first recess 700R1, a width in the second direction D2 of the second recess 700R2, and a width in the second direction D2 of the third recess 700R3.

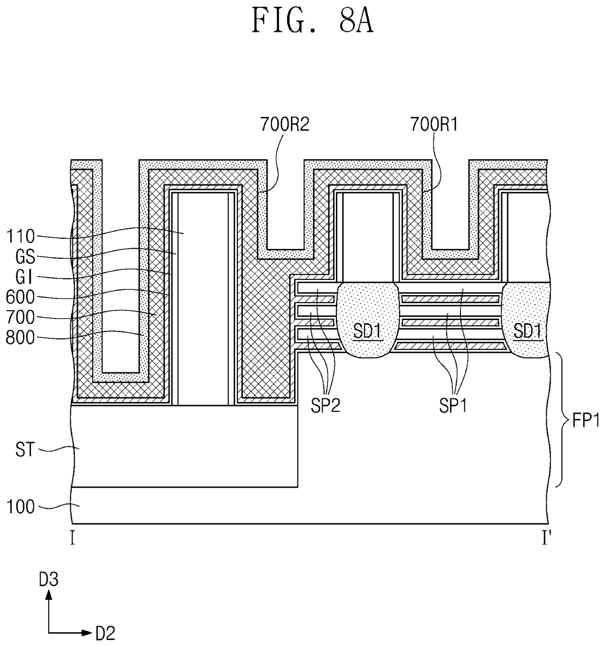

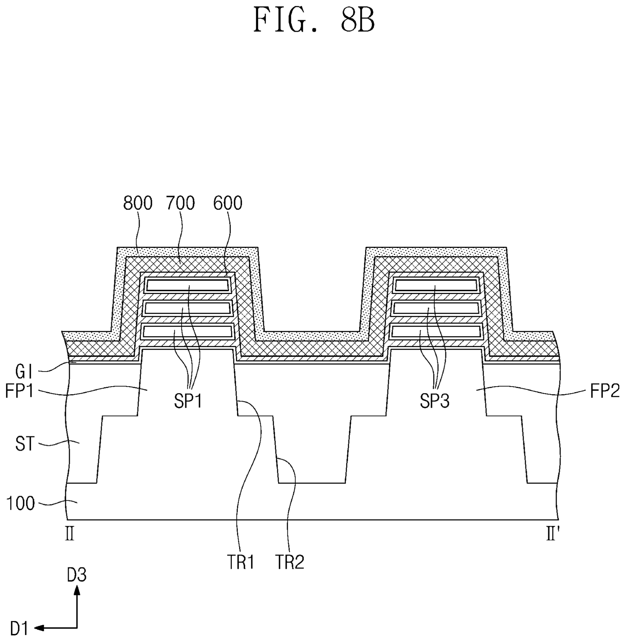

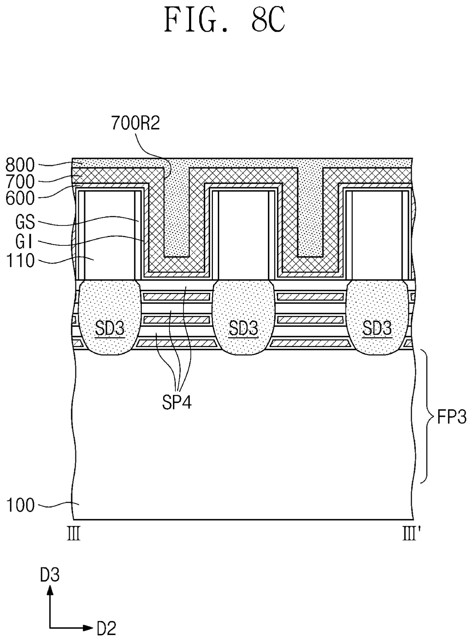

Referring to FIGS. 8A, 8B, and 8C, a preliminary dielectric pattern 800 may be formed to cover the second preliminary conductive layer 700. The preliminary dielectric pattern 800 may include, for example, polysilicon, SiO₂, SiN, H₃PO₄, or HF. The preliminary dielectric pattern 800 may fill the fourth recess 700R4.

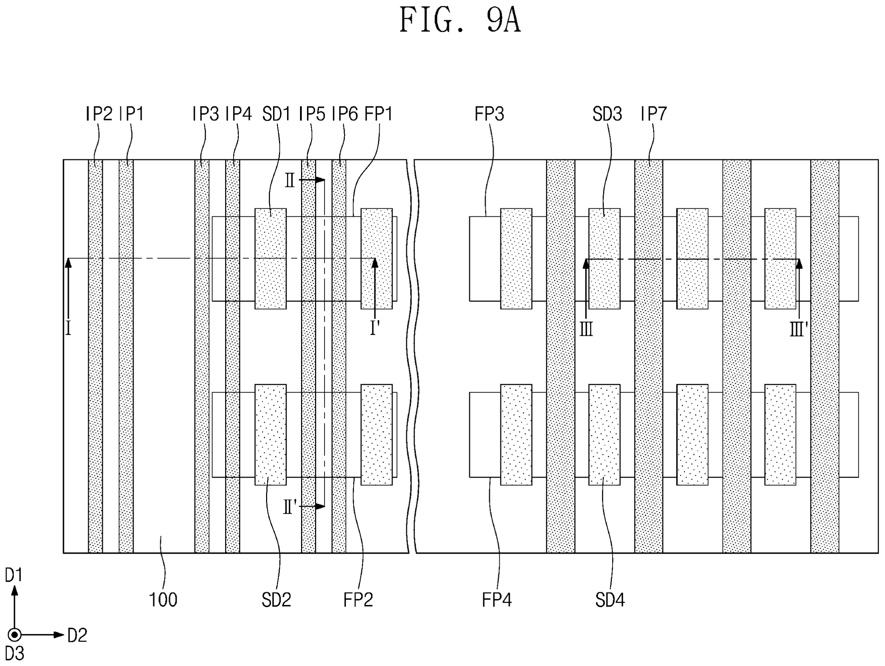

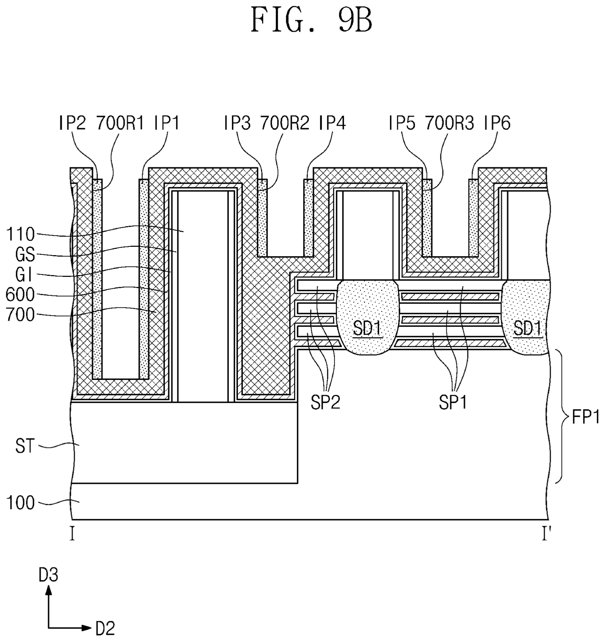

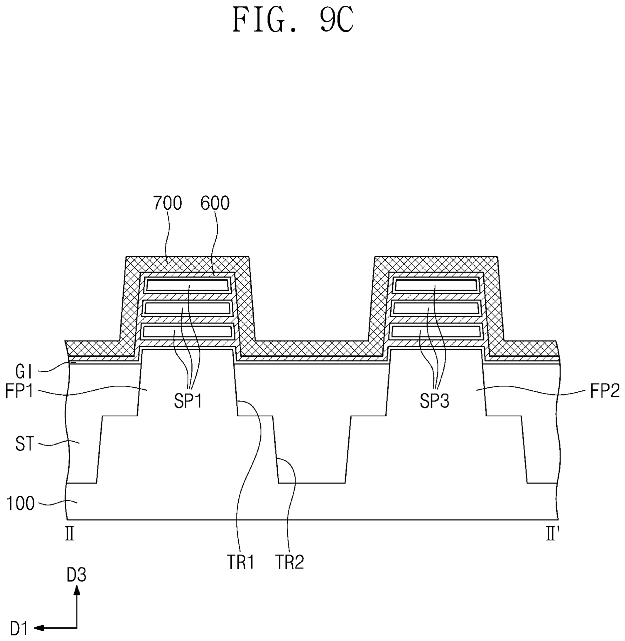

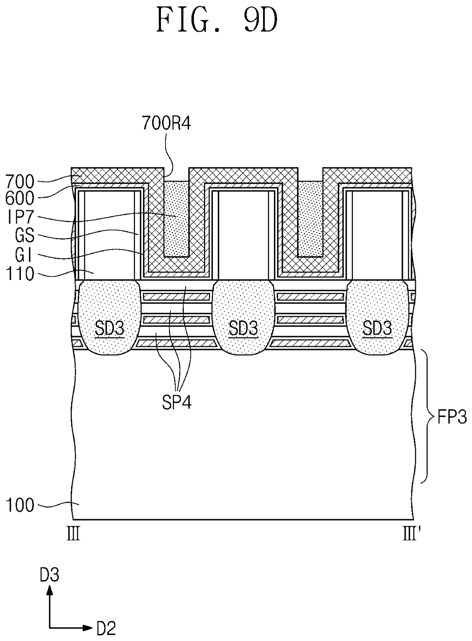

Referring to FIGS. 9A, 9B, 9C, and 9D, a portion of the preliminary dielectric pattern 800 may be etched. The partial removal of the preliminary dielectric pattern 800 may include performing an etch-back process. The partial removal of the preliminary dielectric pattern 800 may include performing an anisotropic etching process on the preliminary dielectric pattern 800. A portion of the preliminary dielectric pattern 800 may be etched to expose the top surface of the second preliminary conductive layer 700.

A portion of the preliminary dielectric pattern 800 may be etched to form a first dielectric pattern IP1, a second dielectric pattern IP2, a third dielectric pattern IP3, a fourth dielectric pattern IP4, a fifth dielectric pattern IP5, a sixth dielectric pattern IP6, and a seventh dielectric pattern IP7.

The first, second, third, fourth, fifth, sixth, and seventh dielectric patterns IP1, IP2, IP3, IP4, IP5, IP6, and IP7 may be spaced apart from each other in the second direction D2. The seventh dielectric pattern IP7 may fill a portion of the fourth recess 700R4.

The first and second dielectric patterns IP1 and IP2 may be spaced apart in the second direction D2 from the first fin pattern FP1. The third dielectric pattern IP3 may be spaced apart in the second direction D2 from the first fin pattern FP1. The fourth dielectric pattern IP4 may overlap in the third direction D3 with the second semiconductor pattern SP2. The fifth and sixth dielectric patterns IP5 and IP6 may overlap in the third direction D3 with the first semiconductor pattern SP1. The seventh dielectric pattern IP7 may overlap in the third direction D3 with the fourth semiconductor pattern SP4.

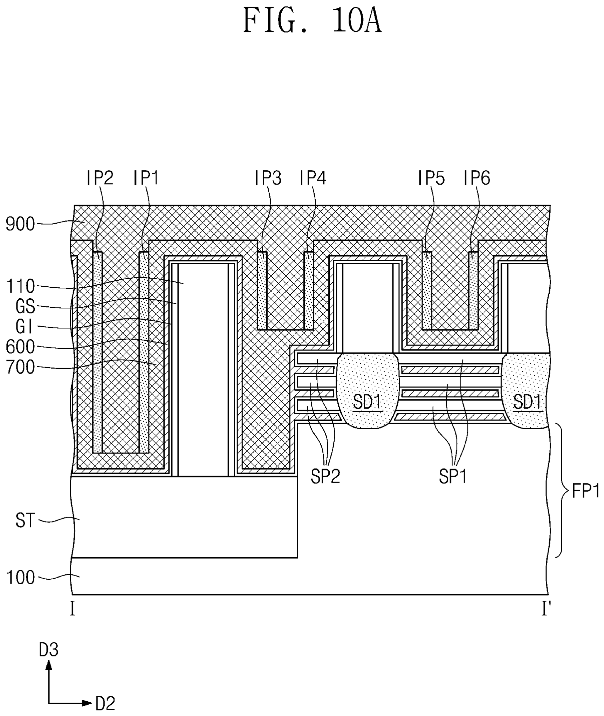

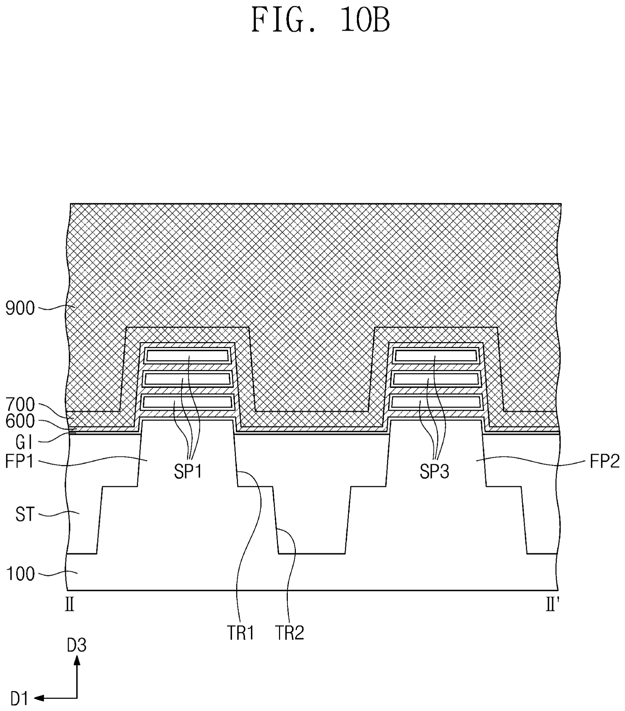

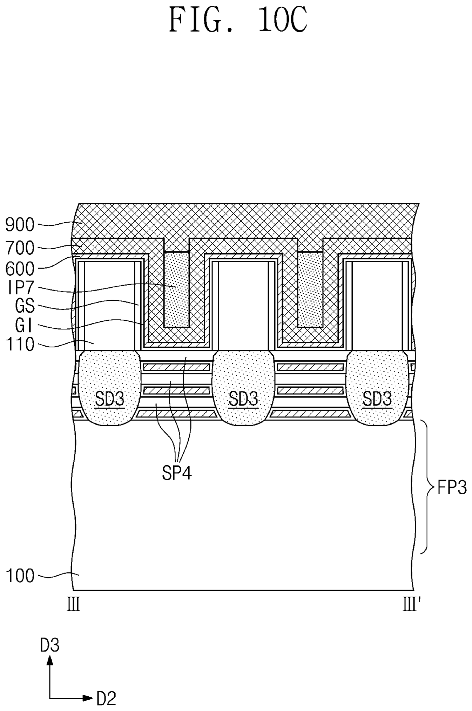

Referring to FIGS. 10A, 10B, and 10C, a third preliminary conductive layer 900 may be formed to cover the second preliminary conductive layer 700 and the first, second, third, fourth, fifth, sixth, and seventh dielectric patterns IP1, IP2, IP3, IP4, IP5, IP6, and IP7. The third preliminary conductive layer 900 may include a conductive material. The third preliminary conductive layer 900 may include the same conductive material as that of the second preliminary conductive layer 700.

The third preliminary conductive layer 900 may fill a gap between the first and second dielectric patterns IP1 and IP2. The third preliminary conductive layer 900 may fill a gap between the third and fourth dielectric patterns IP3 and IP4. The third preliminary conductive layer 900 may fill a gap between the fifth and sixth dielectric patterns IP5 and IP6.

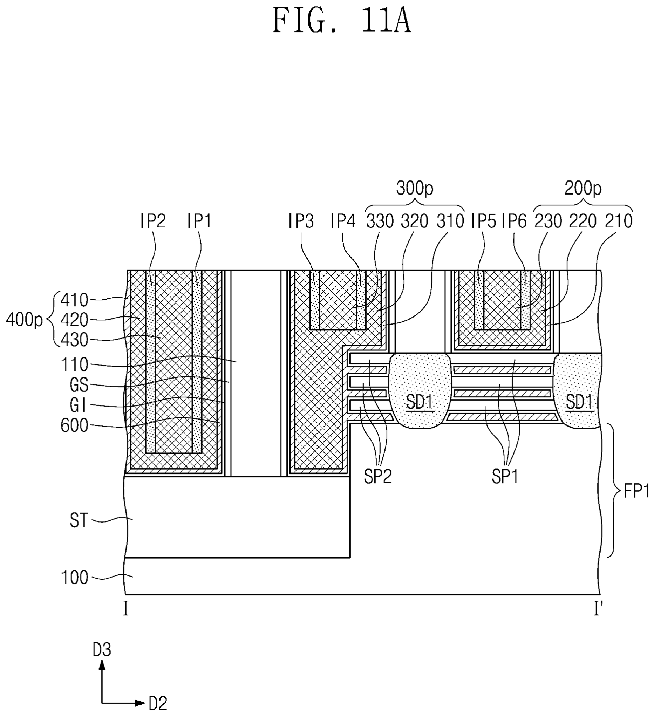

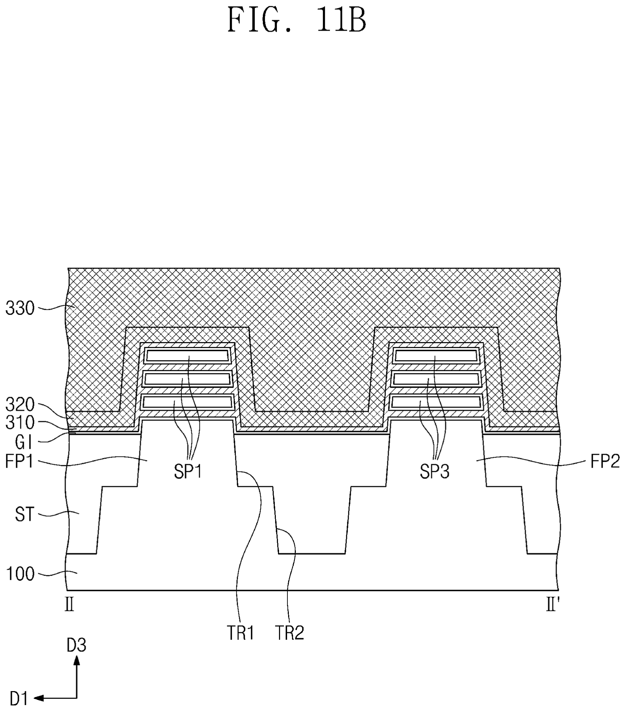

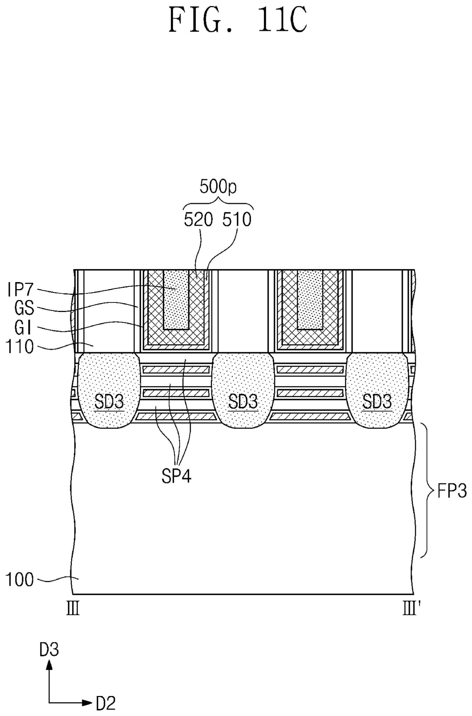

Referring to FIGS. 11A, 11B, and 11C, an etching may be performed on a portion of each of the first preliminary conductive layer 600, the second preliminary conductive layer 700, the third preliminary conductive layer 900, the first to seventh dielectric patterns IP1 to IP7, the first interlayer dielectric layer 110, the gate spacer GS, and the gate dielectric layer GI.

A chemical mechanical polishing (CMP) process may be performed for the partial etching of each of the first preliminary conductive layer 600, the second preliminary conductive layer 700, the third preliminary conductive layer 900, the first to seventh dielectric patterns IP1 to IP7, the first interlayer dielectric layer 110, the gate spacer GS, and the gate dielectric layer GI.

A portion of each of the first preliminary conductive layer 600, the second preliminary conductive layer 700, and the third preliminary conductive layer 900 may be etched to form a first preliminary gate structure 200p, a second preliminary gate structure 300p, a third preliminary gate structure 500p, and a preliminary outer gate structure 400p.

A portion of the first preliminary conductive layer 600 may be etched to form an outer conductive layer 210 of the first preliminary gate structure 200p, an outer conductive layer 310 of the second preliminary gate structure 300p, an outer conductive layer 510 of the third preliminary gate structure 500p, and an outer conductive layer 410 of the preliminary outer gate structure 400p.

A portion of the second preliminary conductive layer 700 may be etched to form a first inner conductive layer 220 of the first preliminary gate structure 200p, a first inner conductive layer 320 of the second preliminary gate structure 300p, an inner conductive layer 520 of the third preliminary gate structure 500p, and a first inner conductive layer 420 of the preliminary outer gate structure 400p.

A portion of the third preliminary conductive layer 900 may be etched to form a second inner conductive layer 230 of the first preliminary gate structure 200p, a second inner conductive layer 330 of the second preliminary gate structure 300p, a second inner conductive layer 530 of the third preliminary gate structure 500p, and a second inner conductive layer 430 of the preliminary outer gate structure 400p.

The first and second dielectric patterns IP1 and IP2 may be disposed between the first inner conductive layer 420 and the second inner conductive layer 430 of the preliminary outer gate structure 400p. The third and fourth dielectric patterns IP3 and IP4 may be disposed between the first inner conductive layer 320 and the second inner conductive layer 330 of the second preliminary gate structure 300p. The fifth and sixth dielectric patterns IP5 and IP6 may be disposed between the first inner conductive layer 220 and the second inner conductive layer 230 of the first preliminary gate structure 200p.

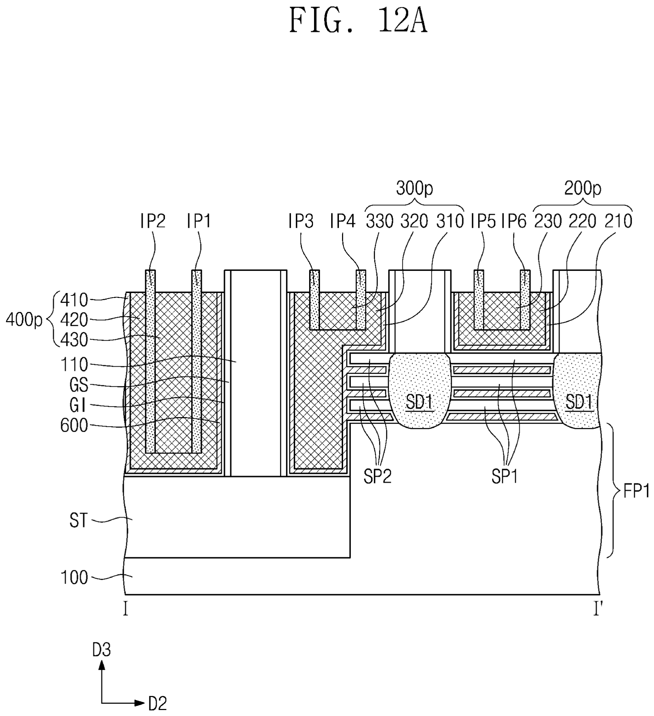

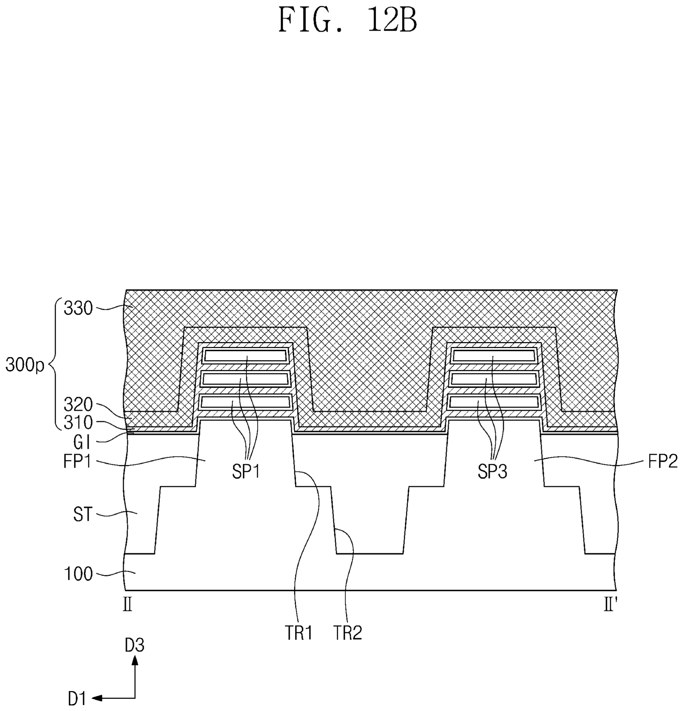

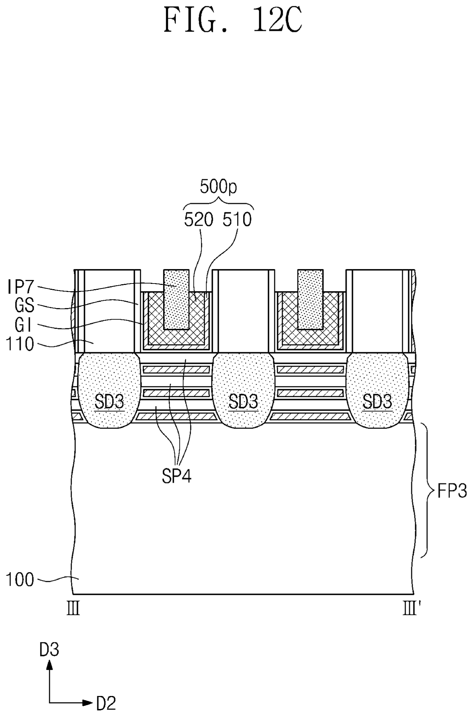

Referring to FIGS. 12A, 12B, and 12C, an etching may be performed on a portion of each of the first preliminary gate structure 200p, the second preliminary gate structure 300p, the preliminary outer gate structure 400p, the third preliminary gate structure 500p, and the gate dielectric layer GI.

Portions of the first inner conductive layer 220 and the second inner conductive layer 230 of the first preliminary gate structure 200p may be etched to allow the fifth dielectric pattern IP5 and the sixth dielectric pattern IP6 to protrude from the first preliminary gate structure 200p.

Portions of the first inner conductive layer 320 and the second inner conductive layer 330 of the second preliminary gate structure 300p may be etched to allow the third dielectric pattern IP3 and the fourth dielectric pattern IP4 to protrude from the second preliminary gate structure 300p.

A portion of the inner conductive layer 520 of the third preliminary gate structure 500p may be etched to allow the seventh dielectric pattern IP7 to protrude from the first preliminary gate structure 200p. A portion of the gate dielectric layer GI may be etched to expose a sidewall of the gate spacer GS.

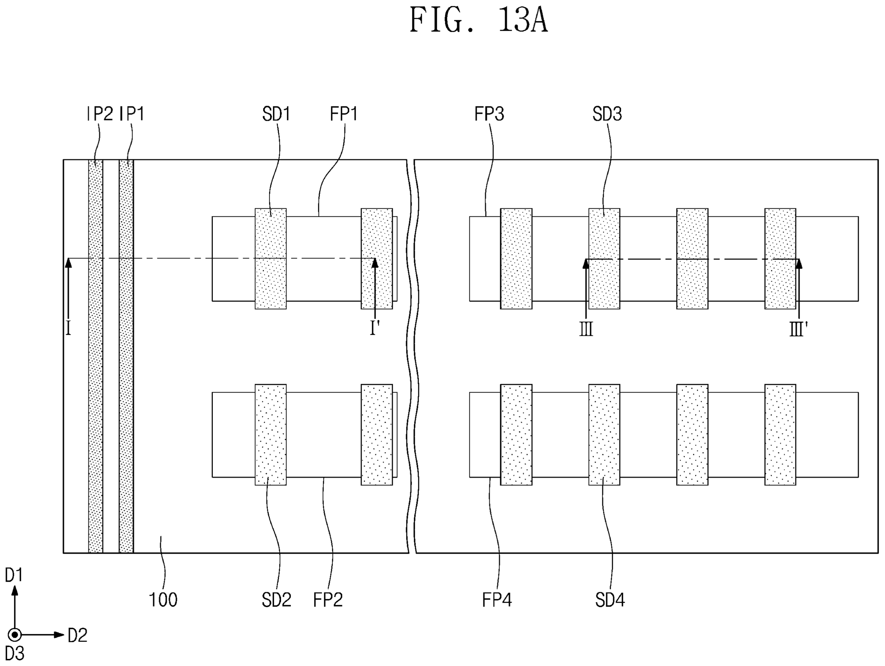

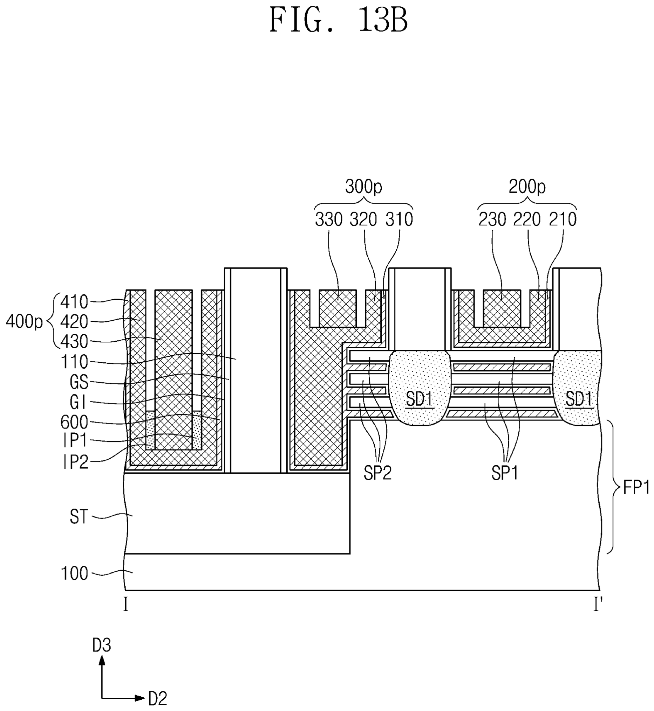

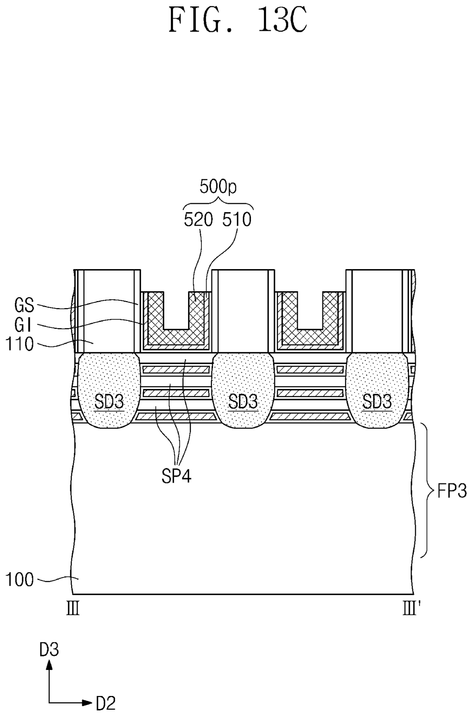

Referring to FIGS. 13A, 13B, and 13C, a removal may be performed on a portion of the first dielectric pattern IP1, a portion of the second dielectric pattern IP2, and the third, fourth, fifth, sixth, and seventh dielectric patterns IP3, IP4, IP5, IP6, and IP7. The removal of a portion of the first dielectric pattern IP1, a portion of the second dielectric pattern IP2, and the third, fourth, fifth, sixth, and seventh dielectric patterns IP3, IP4, IP5, IP6, and IP7 may include, for example, using NH4OH to selectively remove the first, second, third, fourth, fifth, sixth, and seventh dielectric patterns IP1, IP2, IP3, IP4, IP5, IP6, and IP7.

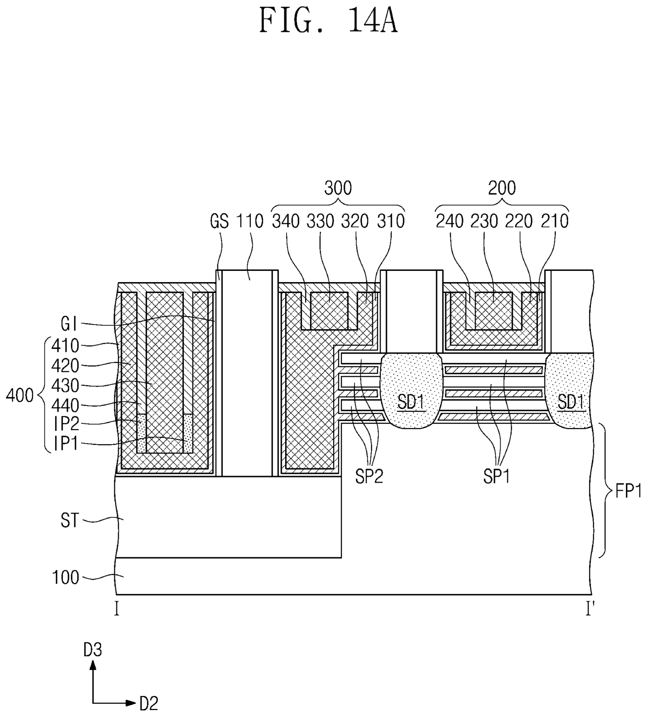

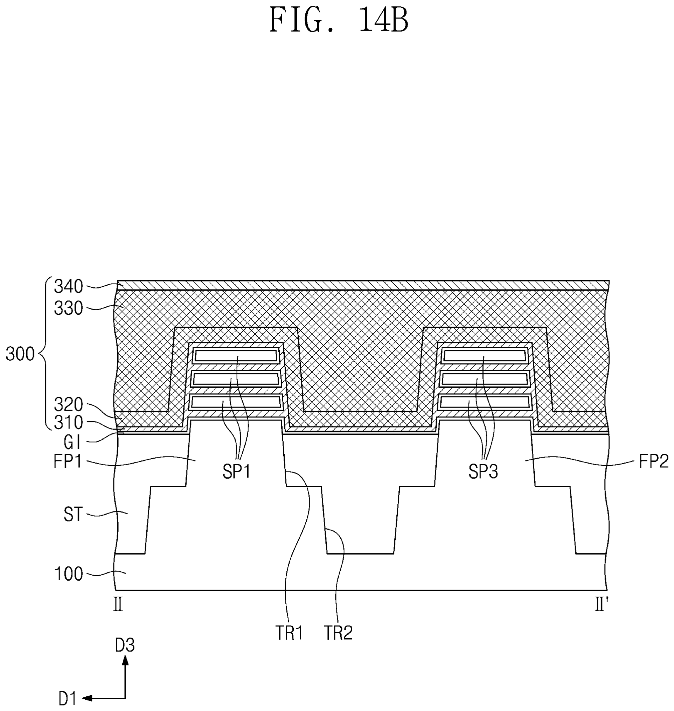

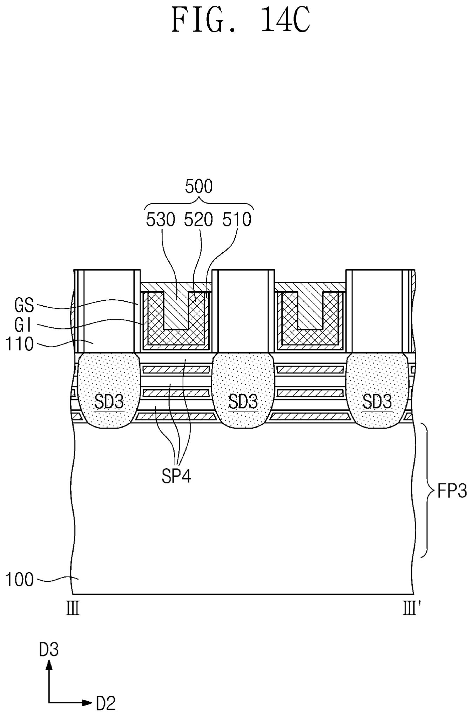

Referring to FIGS. 14A, 14B, and 14C, a filler conductive layer 240 may be formed on the first preliminary gate structure 200p. The filler conductive layer 240 and the first preliminary gate structure 200p may be defined as a first gate structure 200. A filler conductive layer 340 may be formed on the second preliminary gate structure 300p. The filler conductive layer 340 and the second preliminary gate structure 300p may be defined as a second gate structure 300. A filler conductive layer 540 may be formed on the third preliminary gate structure 500p. The filler conductive layer 540 and the third preliminary gate structure 500p may be defined as a third gate structure 500. A filler conductive layer 440 may be formed on the preliminary outer gate structure 400p. An outer gate structure 400 may be defined by the filler conductive layer 440, the first dielectric pattern IP1, the second dielectric pattern IP2, and the preliminary outer gate structure 400p.

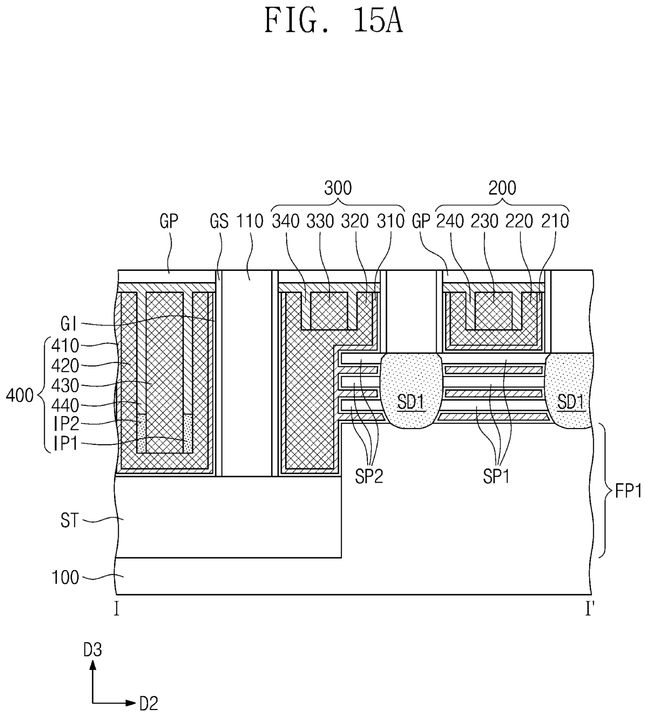

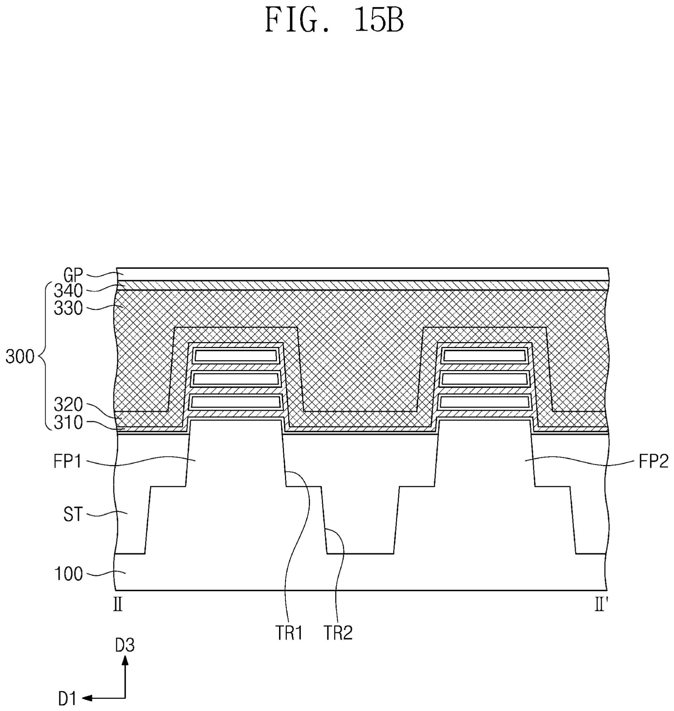

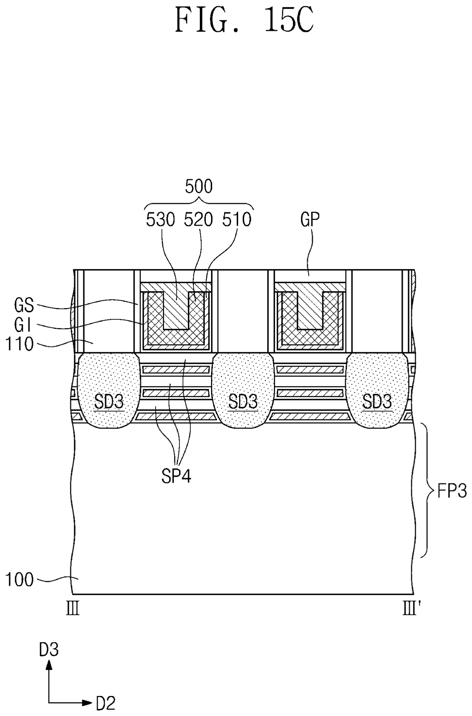

Referring to FIGS. 15A, 15B, and 15C, gate capping patterns GP may be formed. The formation of the gate capping patterns GP may include forming a preliminary gate capping layer to cover the first, second, and third gate structures 200, 300, and 500, the outer gate structure 400, the first interlayer dielectric layer 110, and the gate spacer GS, and then etching the preliminary gate capping layer. When the preliminary gate capping layer is etched, an etching may be performed on a portion of the gate spacer GS and the first interlayer dielectric layer 110.

Referring to FIGS. 1A, 1B, 1C, 1D, 1E, 1F, 1G, and 1H, a second interlayer dielectric layer 120 may be formed on the first interlayer dielectric layer 110. Active contacts AC may be formed to penetrate the second interlayer dielectric layer 120 and the first interlayer dielectric layer 110. Gate contacts GC may be formed to penetrate the second interlayer dielectric layer 120 and the gate capping pattern GP.

A third interlayer dielectric layer 130 may be formed on the second interlayer dielectric layer 120. A first wiring structure M1 may be formed in the third interlayer dielectric layer 130. A fourth interlayer dielectric layer 140 may be formed on the third interlayer dielectric layer 130 and the first wiring structure M1. A second wiring structure M2 may be formed in the fourth interlayer dielectric layer 140.

A method of fabricating a semiconductor device according to one or more embodiments may include forming the first to seventh dielectric patterns IP1 to IP7 on the second preliminary conductive layer 700, and then forming the third preliminary conductive layer 900 to fill a gap between the first and second dielectric pattern IP1 and IP2, a gap between the third and fourth dielectric patterns IP3 and IP4, and a gap between the fifth and sixth dielectric patterns IP5 and IP6. Therefore, a planarization may be performed in a process for forming the first and second gate structure 200 and 300 whose widths are greater than that of the third gate structure 500.

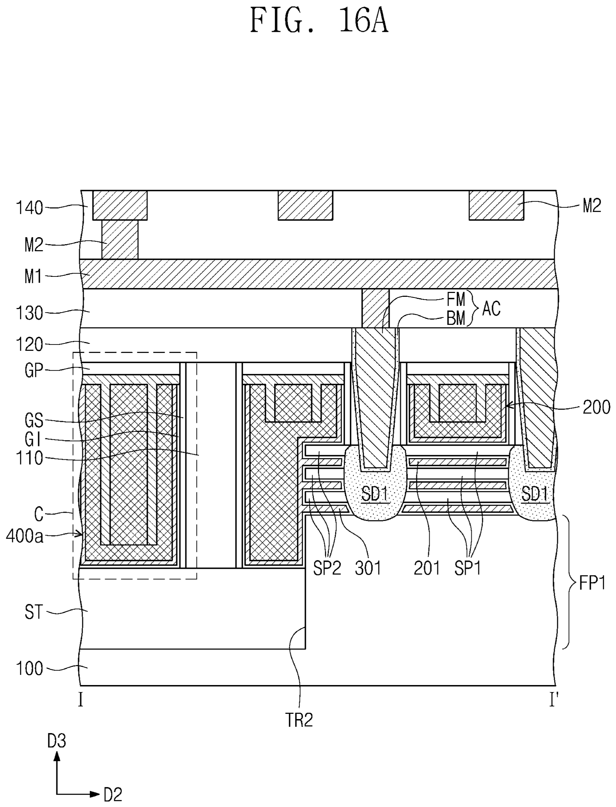

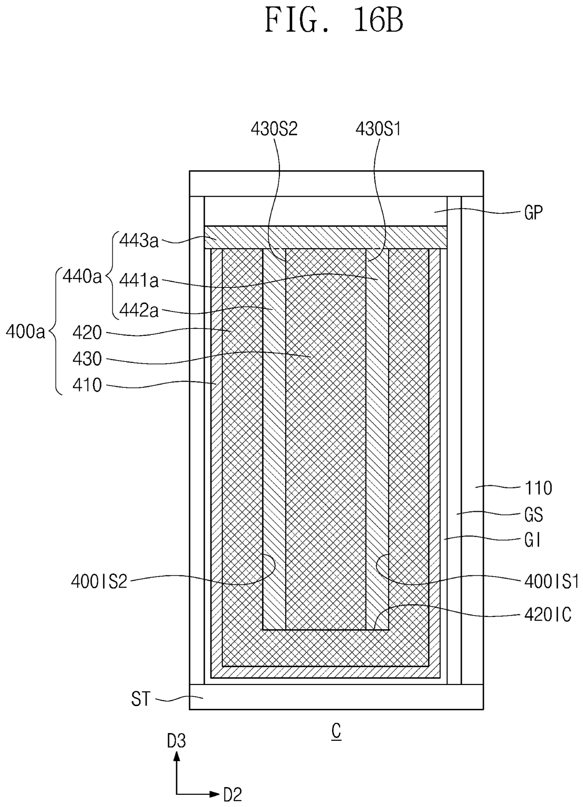

FIGS. 16A and 16B illustrate cross-sectional views showing a semiconductor device according to one or more embodiments. Except as otherwise discussed below, a semiconductor device in accordance with FIGS. 16A and 16B may be analogous to a semiconductor device in accordance with FIGS. 1A to 1H.

Referring to FIGS. 16A and 16B, an outer gate structure 400a may include an outer conductive layer 410, a first inner conductive layer 420, a second inner conductive layer 430, and a filler conductive layer 440a.

The filler conductive layer 440a may include a first portion 441a, a second portion 442a, and a third portion 443a. The first portion 441a and the second portion 442a of the filler conductive layer 440a may be in contact with the inner connection surface 420IC of the first inner conductive layer 420.

A thickness in the third direction D3 of the first and second portions 441a and 442a of the filler conductive layer 440a may be the same as a length in the third direction D3 of the first inner sidewall 420IS1 of the first inner conductive layer 420 and a length in the third direction D3 of the second inner sidewall 420IS2 of the first inner conductive layer 420.

When the first, second, third, fourth, fifth, sixth, and seventh dielectric patterns IP1, IP2, IP3, IP4, IP5, IP6, and IP7 are removed according to FIGS. 13A to 13C, the first and second dielectric patterns IP1 and IP2 may all be removed to fabricate a semiconductor device in accordance with FIGS. 16A and 16B.

In a semiconductor device according to one or more embodiments, the outer gate structure 400a may not include any of the first dielectric pattern IP1 and the second dielectric pattern IP2. Therefore, the outer gate structure 400a may improve in electrical properties.

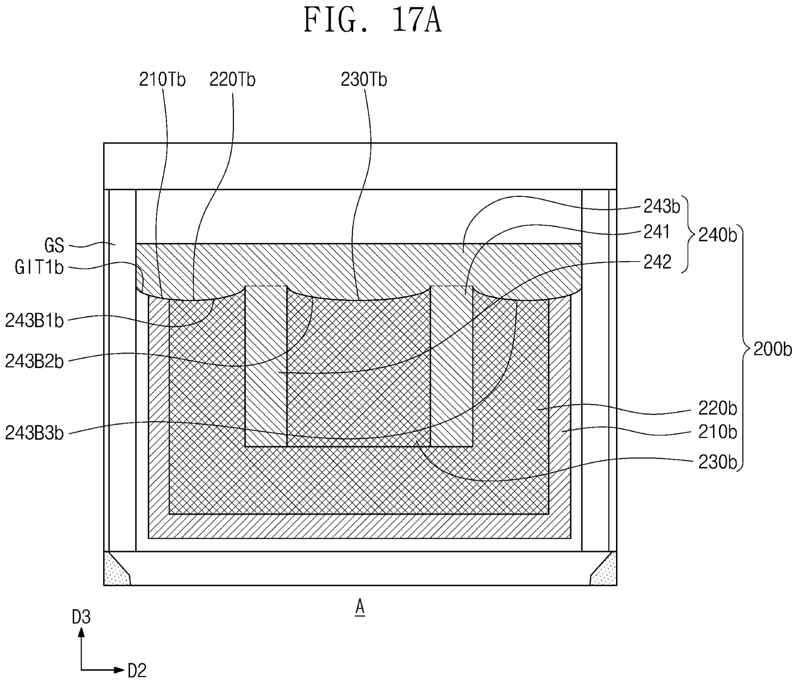

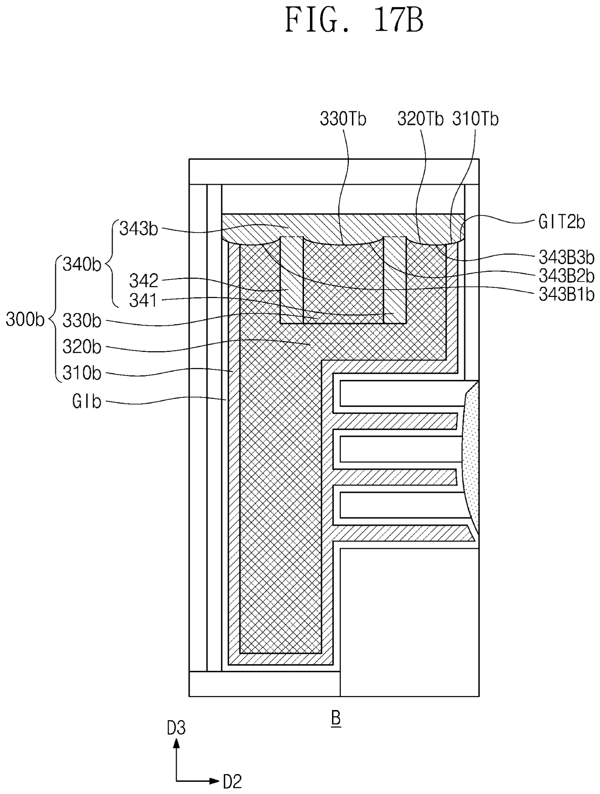

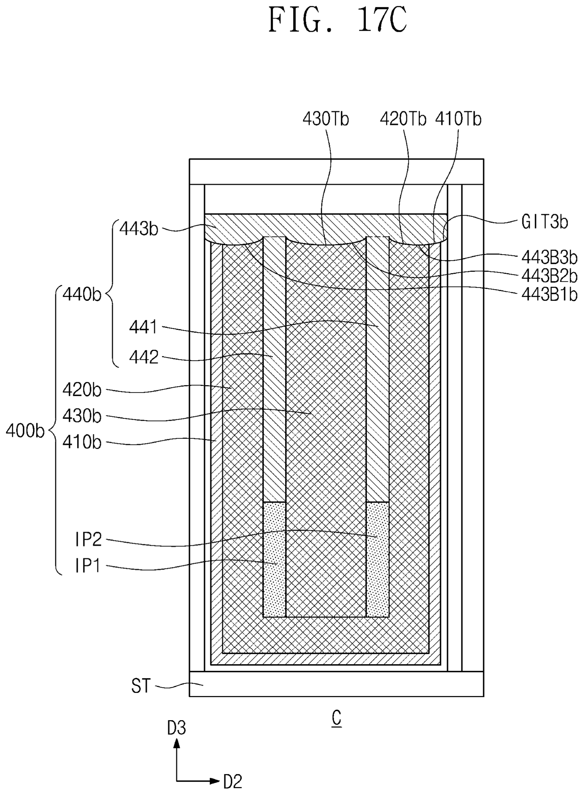

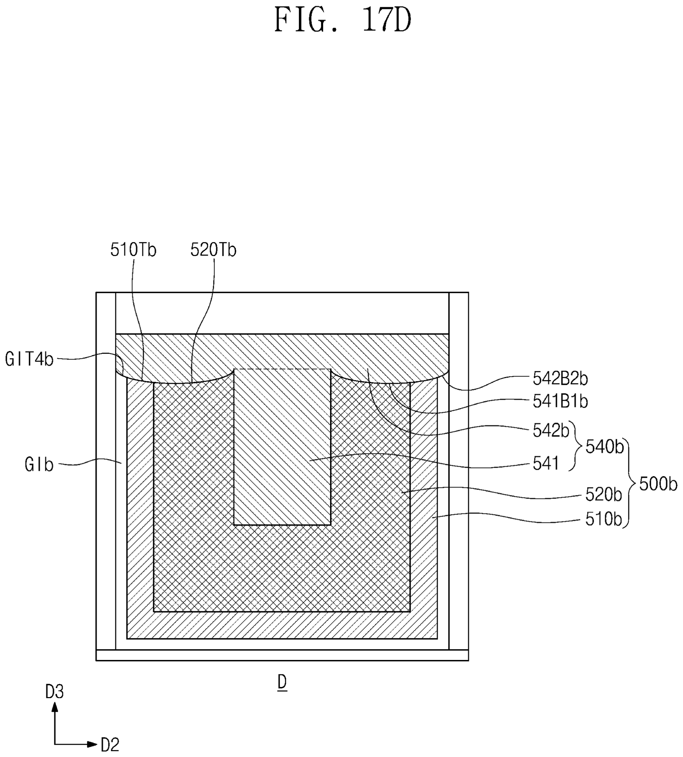

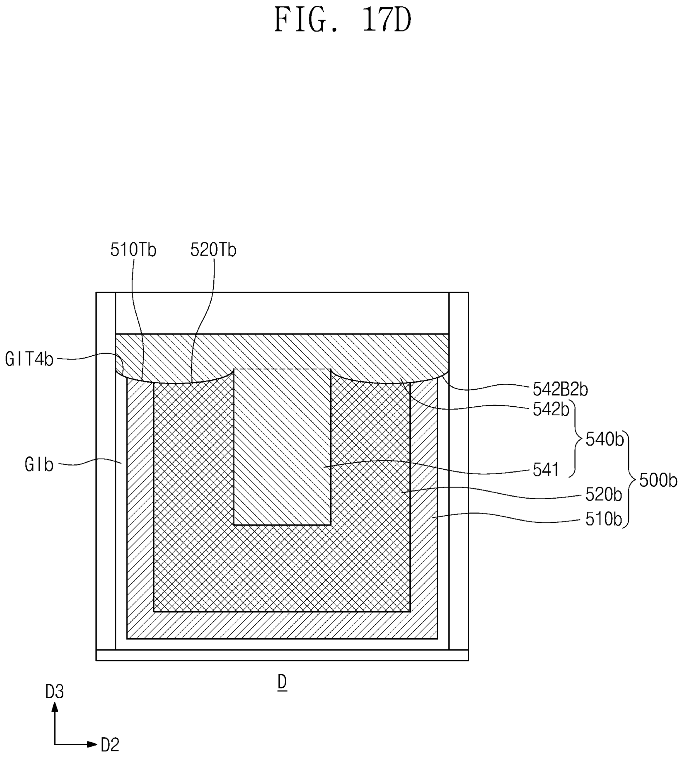

FIGS. 17A, 17B, 17C, and 17D illustrate cross-sectional views showing a semiconductor device according to one or more embodiments. Except as otherwise discussed below, a semiconductor device in accordance with FIGS. 17A to 17C may be analogous to a semiconductor device in accordance with FIGS. 1A to 1H. FIG. 17A may correspond to FIG. 1E. FIG. 17B may correspond to FIG. 1F. FIG. 17C may correspond to FIG. 1G. FIG. 17D may correspond to FIG. 1H.

Referring to FIGS. 17A, 17B, 17C, and 17D, there may be provided a first gate structure 200b, a second gate structure 300b, an outer gate structure 400b, a third gate structure 500b, and a gate dielectric layer GIb. The gate dielectric layer GIb may have a curved top surface GITb.

The first gate structure 200b may include an outer conductive layer 210b, a first inner conductive layer 220b, a second inner conductive layer 230b, and a filler conductive layer 240b. The second gate structure 300b may include an outer conductive layer 310b, a first inner conductive layer 320b, a second inner conductive layer 330b, and a filler conductive layer 340b. The outer gate structure 400b may include an outer conductive layer 410b, a first inner conductive layer 420b, a second inner conductive layer 430b, a filler conductive layer 440b, a first dielectric pattern IP1, and a second dielectric pattern IP2. The third gate structure 500b may include an outer conductive layer 510b, an inner conductive layer 520b, and a filler conductive layer 540b.

The filler conductive layer 240b of the first gate structure 200b may include a first portion 241, a second portion 242, and a third portion 243b. The filler conductive layer 340b of the second gate structure 300b may include a first portion 341, a second portion 342, and a third portion 343b. The filler conductive layer 440b of the outer gate structure 400b may include a first portion 441, a second portion 442, and a third portion 443b. The filler conductive layer 540b of the third gate structure 500b may include a first portion 541 and a second portion 542b.

The outer conductive layer 210b, the first inner conductive layer 220b, and the second inner conductive layer 230b of the first gate structure 200b may respectively have curved top surfaces 210Tb, 220Tb, and 230Tb, and the gate dielectric layer GIb may have a curved first top surface GIT1b.

In the first gate structure 200b, the third portion 243b of the filler conductive layer 240b may have a first bottom surface 243B1b, a second bottom surface 243B2b, and a third bottom surface 243B3b that are spaced apart from each other in the second direction D2. In the first gate structure 200b, the first bottom surface 243B1b and the third bottom surface 243B3b of the third portion 243b of the filler conductive layer 240b may be in contact with the top surface 210Tb of the outer conductive layer 210b and the top surface 220Tb of the first inner conductive layer 220b.

In the first gate structure 200b, a curved surface may be given to the first bottom surface 243B1b, the second bottom surface 243B2b, and the third bottom surface 243B3b of the third portion 243b of the filler conductive layer 240b. In the first gate structure 200b, the first bottom surface 243B1b, the second bottom surface 243B2b, and the third bottom surface 243B3b of the third portion 243b of the filler conductive layer 240b may be convex in a direction counter to the third direction D3.

The outer conductive layer 310b, the first inner conductive layer 320b, and the second inner conductive layer 330b of the second gate structure 300b may respectively have curved top surfaces 310Tb, 320Tb, and 330Tb, and the gate dielectric layer GIb may have a curved second top surface GIT2b.

In the second gate structure 300b, the third portion 343b of the filler conductive layer 340b may have a first bottom surface 343B1b, a second bottom surface 343B2b, and a third bottom surface 343B3b that are spaced apart from each other in the second direction D2. In the second gate structure 300b, the first bottom surface 343B1b and the third bottom surface 343B3b of the third portion 343b of the filler conductive layer 340b may be in contact with the top surface 310Tb of the outer conductive layer 310b and the top surface 320Tb of the first inner conductive layer 320b.

A curved surface may be given to the first bottom surface 343B1b, the second bottom surface 343B2b, and the third bottom surface 343B3b of the third portion 343b of the filler conductive layer 340b in the second gate structure 300b. In the second gate structure 300b, the first bottom surface 343B1b, the second bottom surface 343B2b, and the third bottom surface 343B3b of the third portion 343b of the filler conductive layer 340b may be convex in a direction counter to the third direction D3.

The outer conductive layer 410b, the first inner conductive layer 420b, and the second inner conductive layer 430b of the outer gate structure 400b may respectively have curved top surfaces 410Tb, 420Tb, and 430Tb, and the gate dielectric layer GIb may have a curved third top surface GIT3b.

In the outer gate structure 400b, the third portion 443b of the filler conductive layer 440b may have a first bottom surface 443B1b, a second bottom surface 443B2b, and a third bottom surface 443B3b that are spaced apart from each other in the second direction D2. In the outer gate structure 400b, the first bottom surface 443B1b and the third bottom surface 443B3b of the third portion 443b of the filler conductive layer 440b may be in contact with the top surface 410Tb of the outer conductive layer 410b and the top surface 420Tb of the first inner conductive layer 420b.

A curved surface may be given to the first bottom surface 443B1b, the second bottom surface 443B2b, and the third bottom surface 443B3b of the third portion 443b of the filler conductive layer 440b in the outer gate structure 400b. In the outer gate structure 400b, the first bottom surface 443B1b, the second bottom surface 443B2b, and the third bottom surface 443B3b of the third portion 443b of the filler conductive layer 440b may be convex in a direction counter to the third direction D3.

The outer conductive layer 510b and the inner conductive layer 520b of the third gate structure 500b may respectively have curved top surfaces 510Tb and 520Tb, and the gate dielectric layer GIb may have a curved fourth top surface GIT4b.

In the third gate structure 500b, the second portion 542b of the filler conductive layer 540b may have a first bottom surface 542B1b and a second bottom surface 542B2b that are spaced apart from each other in the second direction D2. In the third gate structure 500b, the first bottom surface 542B1b and the second bottom surface 542B2b of the second portion 542b of the filler conductive layer 540b may be in contact with the top surface 510Tb of the outer conductive layer 510b and the top surface 520Tb of the inner conductive layer 520b.

A curved surface may be given to the first bottom surface 542B1b and the second bottom surface 542B2b of the second portion 542b of the filler conductive layer 540b in the third gate structure 500b. In the third gate structure 500b, the first bottom surface 542B1b and the second bottom surface 542B2b of the second portion 542b of the filler conductive layer 540b may be convex in a direction counter to the third direction D3.

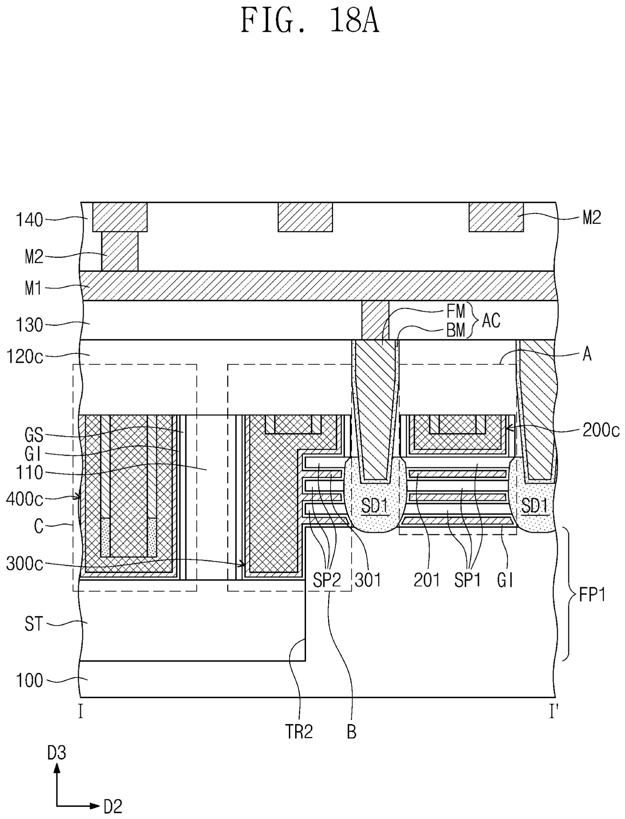

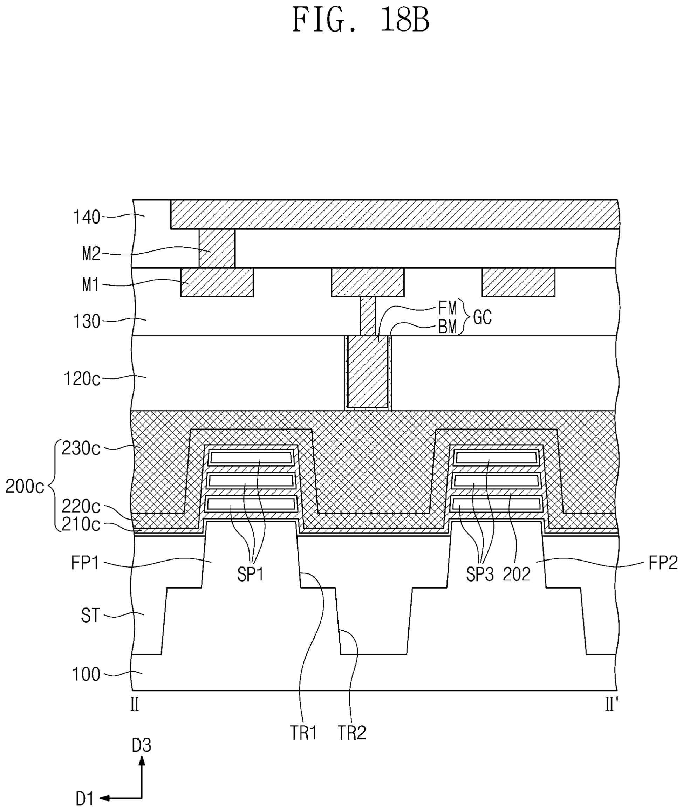

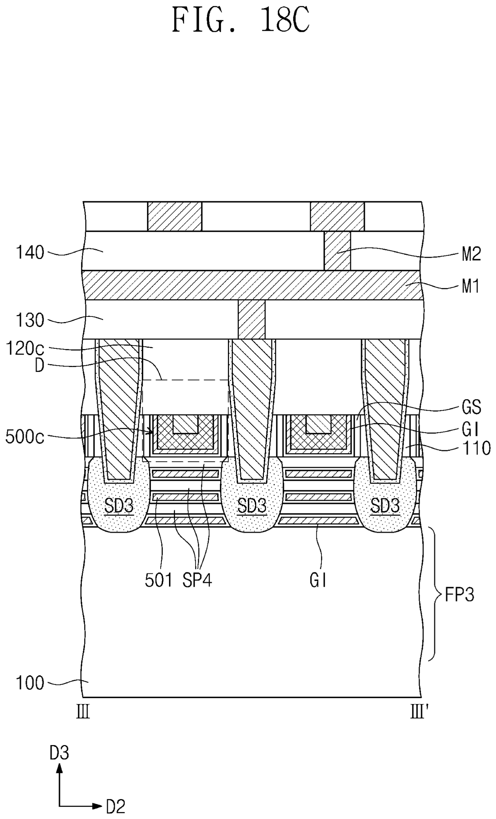

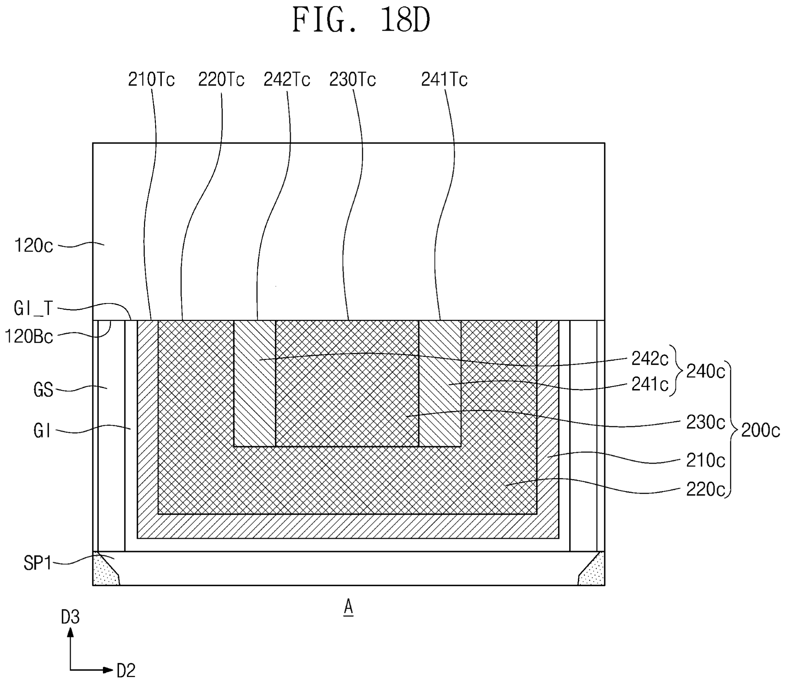

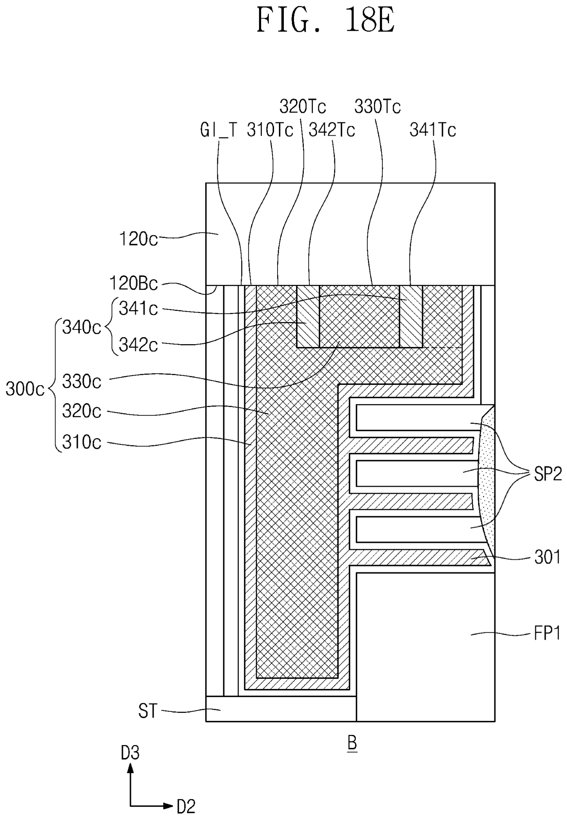

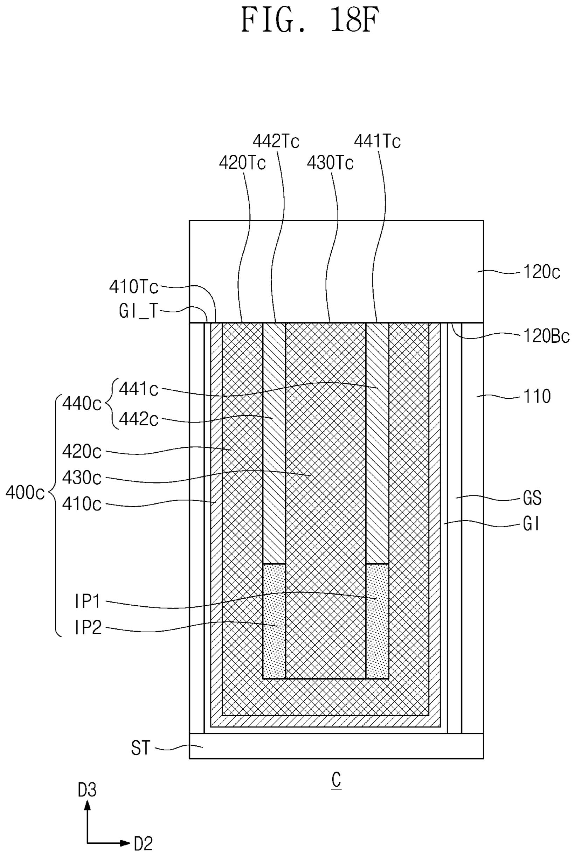

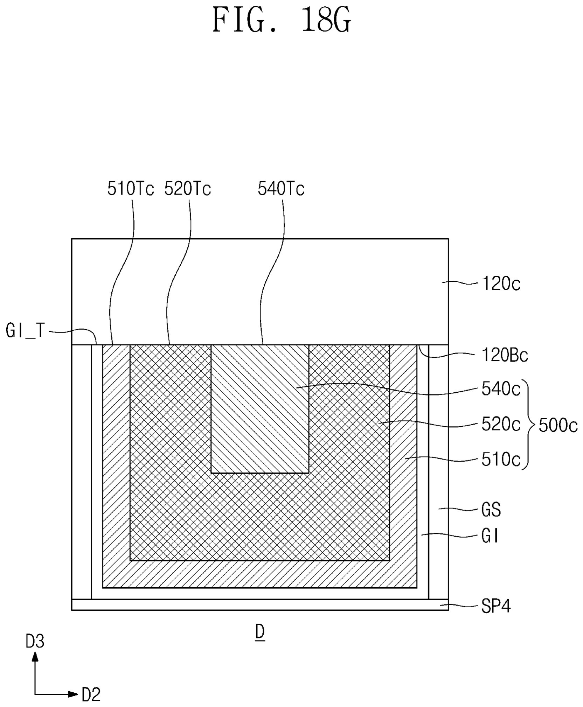

FIGS. 18A, 18B, 18C, 18D, 18E, 18F, and 18G illustrate cross-sectional views showing a semiconductor device according to one or more embodiments. Except as otherwise discussed below, a semiconductor device in accordance with FIGS. 18A to 18G may be analogous to a semiconductor device in accordance with FIGS. 1A to 1H.

Referring to FIGS. 18A, 18B, 18C, 18D, 18E, 18F, and 18G, there may be provided a first gate structure 200c, a second gate structure 300c, a third gate structure 500c, and an outer gate structure 400c. A second interlayer dielectric layer 120c may be provided on the outer gate structure 400c and the first, second, and third gate structures 200c, 300c, and 500c.

The first gate structure 200c may include an outer conductive layer 210c, a first inner conductive layer 220c, a second inner conductive layer 230c, and a filler conductive layer 240c. The filler conductive layer 240c of the first gate structure 200c may include a first portion 241c and a second portion 242c. The second gate structure 300c may include an outer conductive layer 310c, a first inner conductive layer 320c, a second inner conductive layer 330c, and a filler conductive layer 340c. The filler conductive layer 340c of the second gate structure 300c may include a first portion 341c and a second portion 342c. The outer gate structure 400c may include an outer conductive layer 410c, a first inner conductive layer 420c, a second inner conductive layer 430c, a filler conductive layer 440c, a first dielectric pattern IP1, and a second dielectric pattern IP2. The filler conductive layer 440c of the outer gate structure 400c may include a first portion 441c and a second portion 442c. The third gate structure 500c may include an outer conductive layer 510c, an inner conductive layer 520c, and a filler conductive layer 540c. The second interlayer dielectric layer 120c may be in contact with top surfaces of the first, second, and third gate structures 200c, 300c, and 500c and a top surface of the outer gate structure 400c.

In the first gate structure 200c, a coplanar relationship may be achieved between a top surface 210Tc of the outer conductive layer 210c, a top surface 220Tc of the first inner conductive layer 220c, a top surface 230Tc of the second inner conductive layer 230c, a top surface 241Tc of the first portion 241c of the filler conductive layer 240c, a top surface 242Tc of the second portion 242c of the filler conductive layer 240c, and a top surface GI_T of the gate dielectric layer GI. A bottom surface 120Bc of the second interlayer dielectric layer 120c may be in contact with the top surface 210Tc of the outer conductive layer 210c, the top surface 220Tc of the first inner conductive layer 220c, the top surface 230Tc of the second inner conductive layer 230c, the top surface 241Tc of the first portion 241c of the filler conductive layer 240c, the top surface 242Tc of the second portion 242c of the filler conductive layer 240c, and the top surface GI_T of the gate dielectric layer GI.

In the second gate structure 300c, a coplanar relationship may be achieved between a top surface 310Tc of the outer conductive layer 310c, a top surface 320Tc of the first inner conductive layer 320c, a top surface 330Tc of the second inner conductive layer 330c, a top surface 341Tc of the first portion 341c of the filler conductive layer 340c, a top surface 342Tc of the second portion 342c of the filler conductive layer 340c, and a top surface GI_T of the gate dielectric layer GI. A bottom surface 120Bc of the second interlayer dielectric layer 120c may be in contact with the top surface 310Tc of the outer conductive layer 310c, the top surface 320Tc of the first inner conductive layer 320c, the top surface 330Tc of the second inner conductive layer 330c, the top surface 341Tc of the first portion 341c of the filler conductive layer 340c, the top surface 342Tc of the second portion 342c of the filler conductive layer 340c, and the top surface GI_T of the gate dielectric layer GI.

In the outer gate structure 400c, a coplanar relationship may be achieved between a top surface 410Tc of the outer conductive layer 410c, a top surface 420Tc of the first inner conductive layer 420c, a top surface 430Tc of the second inner conductive layer 430c, a top surface 441Tc of the first portion 441c of the filler conductive layer 440c, a top surface 442Tc of the second portion 442c of the filler conductive layer 440c, and a top surface GI_T of the gate dielectric layer GI. A bottom surface 120Bc of the second interlayer dielectric layer 120c may be in contact with the top surface 410Tc of the outer conductive layer 410c, the top surface 420Tc of the first inner conductive layer 420c, the top surface 430Tc of the second inner conductive layer 430c, the top surface 441Tc of the first portion 441c of the filler conductive layer 440c, the top surface 442Tc of the second portion 442c of the filler conductive layer 440c, and the top surface GI_T of the gate dielectric layer GI.

In the third gate structure 500c, a coplanar relationship may be achieved between a top surface 510Tc of the outer conductive layer 510c, a top surface 520Tc of the inner conductive layer 520c, a top surface 540Tc of the filler conductive layer 540c, and a top surface GI_T of the gate dielectric layer GI. A bottom surface 120Bc of the second interlayer dielectric layer 120c may be in contact with the top surface 510Tc of the outer conductive layer 510c, the top surface 520Tc of the inner conductive layer 520c, the top surface 540Tc of the filler conductive layer 540c, and the top surface GI_T of the gate dielectric layer GI.

A semiconductor device according to one or more embodiments may include a filler conductive layer disposed between a first inner conductive layer and a second inner conductive layer of a gate structure. Therefore, in a procedure for forming the gate structure having a relatively large width, the gate structure may be prevented from being excessively etched at an upper portion thereof.

Although the present disclosure has been described in connection with the one or more embodiments of the disclosure illustrated in the accompanying drawings, it will be understood by one of ordinary skill in the art that variations in form and detail may be made therein without departing from the scope of the disclosure. The above disclosed embodiments should thus be considered illustrative and not restrictive.

Embodiments are set out in the following clauses:
Clause 1. A semiconductor device comprising:
   a source/drain pattern;
   a semiconductor pattern connected to the source/drain pattern;
   a first gate structure that overlaps the semiconductor pattern; and
   a gate dielectric layer between the first gate structure and the semiconductor pattern,
   wherein the first gate structure comprises:
      an outer conductive layer on the gate dielectric layer;
      a first inner conductive layer on the outer conductive layer and spaced apart from the gate dielectric layer;
      a second inner conductive layer on the first inner conductive layer and spaced apart from the outer conductive layer; and
      a filler conductive layer on the first inner conductive layer and the second inner conductive layer,
   wherein the filler conductive layer of the first gate structure comprises a first portion and a second portion,
   wherein the first portion of the filler conductive layer of the first gate structure and the second portion of the filler conductive layer of the first gate structure are between the first inner conductive layer of the first gate structure and the second inner conductive layer of the first gate structure,
   wherein the first portion of the filler conductive layer of the first gate structure and the second portion of the filler conductive layer of the first gate structure are spaced apart from each other,
   wherein the second inner conductive layer of the first gate structure is between the first portion of the filler conductive layer of the first gate structure and the second portion of the filler conductive layer of the first gate structure, and
   wherein the first portion of the filler conductive layer of the first gate structure and the second portion of the filler conductive layer of the first gate structure are spaced apart from the outer conductive layer of the first gate structure.
Clause 2. The semiconductor device of clause 1, further comprising a second gate structure spaced apart from the first gate structure,
   wherein the second gate structure comprises:
      an outer conductive layer on the gate dielectric layer;
      an inner conductive layer on the outer conductive layer and spaced apart from the gate dielectric layer; and
      a filler conductive layer on the inner conductive layer,
   wherein the filler conductive layer of the second gate structure comprises a first portion of the inner conductive layer of the second gate structure, and
   wherein a width of the first portion of the filler conductive layer of the second gate structure is greater than a width of the first portion of the filler conductive layer of the first gate structure.
Clause 3. The semiconductor device of clause 2, wherein the first portion of the filler conductive layer of the second gate structure has a first sidewall and a second sidewall that are opposite to each other, and
   wherein the first sidewall of the first portion of the filler conductive layer of the second gate structure and the second sidewall of the first portion of the filler conductive layer of the second gate structure is in contact with the inner conductive layer of the second gate structure.
Clause 4. The semiconductor device of clause 2 or clause 3, wherein a width of the second gate structure is less than a width of the first gate structure.
Clause 5. The semiconductor device of any of clauses 2 to 4, wherein the width of the first portion of the filler conductive layer of the second gate structure is less than twice the width of the first portion of the filler conductive layer of the first gate structure.
Clause 6. The semiconductor device of any of clauses 1 to 5, further comprising an outer gate structure spaced apart from the first gate structure,
   wherein the outer gate structure does not overlap the semiconductor pattern, and
   wherein the outer gate structure comprises an outer conductive layer and a dielectric pattern of the outer conductive layer.
Clause 7. The semiconductor device of clause 6, wherein the dielectric pattern comprises a first dielectric pattern and a second dielectric pattern that are spaced apart from each other, and
   wherein the outer gate structure further comprises an inner conductive layer between the first dielectric pattern and the second dielectric pattern.
Clause 8. The semiconductor device of clause 7, wherein the first dielectric pattern, the second dielectric pattern, the first portion of the filler conductive layer of the first gate structure, and the second portion of the filler conductive layer of the first gate structure have the same width.
Clause 9. A semiconductor device comprising:
   a source/drain pattern;
   a semiconductor pattern connected to the source/drain pattern;
   a gate structure that overlaps the semiconductor pattern; and
   a gate dielectric layer between the gate structure and the semiconductor pattern,
   wherein the gate structure comprises:
      a first inner conductive layer spaced apart from the gate dielectric layer;
      a second inner conductive layer on the first inner conductive layer; and
      a filler conductive layer on the first inner conductive layer and the second inner conductive layer,
   wherein the filler conductive layer comprises a first portion and a second portion that are spaced apart from each other,
   wherein the second inner conductive layer is between the first portion of the filler conductive layer and the second portion of the filler conductive layer, and
   wherein a bottom surface of the first portion of the filler conductive layer and a bottom surface of the second portion of the filler conductive layer are in contact with the first inner conductive layer.
Clause 10. The semiconductor device of clause 9, wherein the gate structure further comprises an outer conductive layer between the first inner conductive layer and the gate dielectric layer, and
   wherein the outer conductive layer comprises a material that is the same as a material of the first inner conductive layer and the second inner conductive layer.

## Claims

1. A semiconductor device comprising:
a source/drain pattern (SD1);
a semiconductor pattern (SP1) connected to the source/drain pattern (SD1);
a gate structure (200) that overlaps the semiconductor pattern (SP1); and
a gate dielectric layer (GI) between the gate structure (200) and the semiconductor pattern (SP1),
wherein the gate structure (200) comprises:
a first inner conductive layer (220);
a second inner conductive layer (230) on the first inner conductive layer (220); and
a filler conductive layer (240) on the first inner conductive layer (220) and the second inner conductive layer (230),
wherein the filler conductive layer (240) comprises a first portion (241) and a second portion (242),
wherein the first portion (241) of the filler conductive layer (240) and the second portion (242) of the filler conductive layer (240) are between the first inner conductive layer (220) and the second inner conductive layer (230),
wherein the first portion (241) of the filler conductive layer (240) and the second portion (242) of the filler conductive layer (240) are spaced apart from each other,
wherein the second inner conductive layer (230) is between the first portion (241) of the filler conductive layer (240) and the second portion (242) of the filler conductive layer (240),
wherein a first sidewall (241S1) of the first portion (241) of the filler conductive layer (240) and a bottom surface (241B) of the first portion (241) of the filler conductive layer (240) are in contact with the first inner conductive layer (220), and
wherein a second sidewall (241S2) of the first portion (241) of the filler conductive layer (240) is in contact with the second inner conductive layer (230).

2. The semiconductor device of claim 1, wherein the filler conductive layer (240) comprises a first conductive material, and
wherein the first inner conductive layer (220) and the second inner conductive layer (230) each comprise a second conductive material different from the first conductive material.

3. The semiconductor device of claim 2, wherein a resistivity of the first conductive material is less than a resistivity of the second conductive material.

4. The semiconductor device of claim 2 or claim 3, wherein the first conductive material comprises tungsten (W), and
the second conductive material comprises titanium nitride (TiN).

5. The semiconductor device of any preceding claim, wherein the first inner conductive layer (220) comprises:
a first inner sidewall (220IS1) in contact with the first portion (241) of the filler conductive layer (240);
a second inner sidewall (220IS2) in contact with the second portion (242) of the filler conductive layer (240); and
a connection surface (220IC) that connects the first inner sidewall (220IS1) and the second inner sidewall (220IS2) to each other, and
wherein the first portion (241) of the filler conductive layer (240), the second portion (242) of the filler conductive layer (240), and the second inner conductive layer (230) are in contact with the connection surface (220IC) of the first inner conductive layer (220).

6. The semiconductor device of any preceding claim, wherein the first sidewall (241S1) of the first portion (241) of the filler conductive layer (240) and the second sidewall (241 S2) of the first portion (241) of the filler conductive layer (240) are opposite to each other.

7. The semiconductor device of any preceding claim, wherein a first sidewall (242S 1) of the second portion (242) of the filler conductive layer (240) and a bottom surface (242B) of the second portion (242) of the filler conductive layer (240) are in contact with the first inner conductive layer (220), and
wherein a second sidewall (242S2) of the second portion (242) of the filler conductive layer (240) is in contact with the second inner conductive layer (230).

8. The semiconductor device of any preceding claim, wherein the filler conductive layer (240) further comprises a third portion (243) that covers the second inner conductive layer (230) and that connects the first portion (241) of the filler conductive layer (240) and the second portion (242) of the filler conductive layer (240) to each other.

9. The semiconductor device of claim 8, wherein the third portion (243) of the filler conductive layer (240) is in contact with the gate dielectric layer (GI), and
wherein the first portion (241) of the filler conductive layer (240) and the second portion (242) of the filler conductive layer (240) are spaced apart from the gate dielectric layer (GI).

10. The semiconductor device of claim 8 or claim 9, wherein the third portion (243) of the filler conductive layer (240) is at a level higher than a level of the first inner conductive layer (220) and a level of the second inner conductive layer (230), and
wherein the first portion (241) of the filler conductive layer (240) and the second portion (242) of the filler conductive layer (240) are at a level that is the same as the level of the first inner conductive layer (220) and the level of the second inner conductive layer (230).

## Amended claims

### Amended claims in accordance with Rule 137(2) EPC.

1. A semiconductor device comprising:
a source/drain pattern (SD1);
a semiconductor pattern (SP1) connected to the source/drain pattern (SD1) along a second direction (D2);
a gate structure (200) that overlaps the semiconductor pattern (SP1); and
a gate dielectric layer (GI) between the gate structure (200) and the semiconductor pattern (SP1),
wherein the gate structure (200) comprises:
a first inner conductive layer (220);
a second inner conductive layer (230) on the first inner conductive layer (220); and
a filler conductive layer (240) on the first inner conductive layer (220) and the second inner conductive layer (230),
wherein the filler conductive layer (240) comprises a first portion (241) and a second portion (242),
wherein, when viewed in a cross section along the second direction (D2):
the first portion (241) of the filler conductive layer (240) and the second portion (242) of the filler conductive layer (240) are between the first inner conductive layer (220) and the second inner conductive layer (230),
the first portion (241) of the filler conductive layer (240) and the second portion (242) of the filler conductive layer (240) are spaced apart from each other,
the second inner conductive layer (230) is between the first portion (241) of the filler conductive layer (240) and the second portion (242) of the filler conductive layer (240),
a first sidewall (241S1) of the first portion (241) of the filler conductive layer (240) and a bottom surface (241B) of the first portion (241) of the filler conductive layer (240) are in contact with the first inner conductive layer (220), and
a second sidewall (241S2) of the first portion (241) of the filler conductive layer (240) is in contact with the second inner conductive layer (230).

2. The semiconductor device of claim 1, wherein the filler conductive layer (240) comprises a first conductive material, and
wherein the first inner conductive layer (220) and the second inner conductive layer (230) each comprise a second conductive material different from the first conductive material.

3. The semiconductor device of claim 2, wherein a resistivity of the first conductive material is less than a resistivity of the second conductive material.

4. The semiconductor device of claim 2 or claim 3, wherein the first conductive material comprises tungsten (W), and
the second conductive material comprises titanium nitride (TiN).

5. The semiconductor device of any preceding claim, wherein the first inner conductive layer (220) comprises:
a first inner sidewall (220IS1) in contact with the first portion (241) of the filler conductive layer (240);
a second inner sidewall (220IS2) in contact with the second portion (242) of the filler conductive layer (240); and
a connection surface (220IC) that connects the first inner sidewall (220IS1) and the second inner sidewall (220IS2) to each other, and
wherein the first portion (241) of the filler conductive layer (240), the second portion (242) of the filler conductive layer (240), and the second inner conductive layer (230) are in contact with the connection surface (220IC) of the first inner conductive layer (220).

6. The semiconductor device of any preceding claim, wherein the first sidewall (241S1) of the first portion (241) of the filler conductive layer (240) and the second sidewall (241 S2) of the first portion (241) of the filler conductive layer (240) are opposite to each other.

7. The semiconductor device of any preceding claim, wherein a first sidewall (242S1) of the second portion (242) of the filler conductive layer (240) and a bottom surface (242B) of the second portion (242) of the filler conductive layer (240) are in contact with the first inner conductive layer (220), and
wherein a second sidewall (242S2) of the second portion (242) of the filler conductive layer (240) is in contact with the second inner conductive layer (230).

8. The semiconductor device of any preceding claim, wherein the filler conductive layer (240) further comprises a third portion (243) that covers the second inner conductive layer (230) and that connects the first portion (241) of the filler conductive layer (240) and the second portion (242) of the filler conductive layer (240) to each other.

9. The semiconductor device of claim 8, wherein the third portion (243) of the filler conductive layer (240) is in contact with the gate dielectric layer (GI), and
wherein the first portion (241) of the filler conductive layer (240) and the second portion (242) of the filler conductive layer (240) are spaced apart from the gate dielectric layer (GI).

10. The semiconductor device of claim 8 or claim 9, wherein the third portion (243) of the filler conductive layer (240) is at a level higher than a level of the first inner conductive layer (220) and a level of the second inner conductive layer (230) relative to the semiconductor pattern (SP1), and
wherein a top surface of the first portion (241) of the filler conductive layer (240) and a top surface of the second portion (242) of the filler conductive layer (240) are at a level that is the same as the level of a top surface (220T) of the first inner conductive layer (220) and the level of a top surface (230T) of the second inner conductive layer (230).
